# EUROPEAN PATENT APPLICATION

(11) **EP 4 723 864 A2**
(43) Date of publication of application: **08.04.2026**
(21) Application number: 25202877.4
(22) Date of filing: 17.09.2025
(51) Int. Cl.: H10W 90/10, H10W 90/20, H10W 90/00

(54) **SEMICONDUCTOR PACKAGE**

(30) Priority: 04.10.2024 KR 20240134562; 08.01.2025 KR 20250002838
(71) Applicant: Samsung Electronics Co., Ltd., Suwon-si, Gyeonggi-do 16677 (KR)
(72) Inventor: JUNG, Seungchul, 16678 Suwon-si (KR); KONG, Tae-Hwang, 16678 Suwon-si (KR); KIM, Sang Joon, 16678 Suwon-si (KR); YUN, Seok Ju, 16678 Suwon-si (KR); JO, Sungeun, 16678 Suwon-si (KR); CHOI, Hun Seong, 16678 Suwon-si (KR)
(74) Representative: Arnold & Siedsma

(57) **Abstract**

A semiconductor package includes a substrate, a platform die provided on the substrate, a memory die provided on the platform die, and a processor die provided on the platform die and provided adjacent to the memory die, wherein the platform die includes a memory controller configured to control data communication between the memory die and the processor die.

## Description

### 1. Field

The disclosure relates to a semiconductor package, and a method of manufacturing the semiconductor package.

### 2. Description of Related Art

A contemporary electronic device requires high performance and energy efficiency and a semiconductor integrated circuit (IC) technique has been continuously developed to satisfy this requirement. Specifically, the rapid development of a high-performance computing device, an artificial intelligence (AI) processor, a graphics processing unit (GPU), a data center, and a mobile device may require a higher processing rate and a greater data processing ability.

To satisfy such requirements, multi-die or system-on-chip (SoC) techniques have been widely used in a semiconductor technical field. These techniques may contribute to increasing spatial efficiency in addition to performance improvement by integrating and operating multiple processors, memories, and various functional blocks into one package.

However, signal integrity and power consumption may still be important challenges to implement efficient connection and communication between dies. Specifically, in a high-performance system, maintaining reliability may be significantly important while optimizing a data transmission rate between multiple processors and memories. For this, a new packaging technique and a power management solution may be required.

In addition, the miniaturization and high-density integration of a semiconductor device increase precision and complexity in a manufacturing process, and thereby, the manufacturing cost increases. Accordingly, there is a demand for innovative design and packaging techniques to maintain high performance yet stay cost-effective.

### SUMMARY

One or more aspects of the disclosure relate to a semiconductor package, and a method of manufacturing the semiconductor package.

According to an aspect of the disclosure, there is provided a semiconductor package including: a platform die preferably provided on a substrate; a memory die provided on the platform die; and a processor die provided on the platform die and provided adjacent to the memory die; wherein the platform die includes a memory controller configured to control data communication between the memory die and the processor die.

The memory die may be configured to transmit data through direct connection to the memory controller.

The memory die comprises a memory stack including stacked memory dies, a number of data lines between the plurality of memory dies of the memory stack may be same as a number of data lines between the memory stack and the memory controller.

The platform die may include a buffer configured to adjust a signal between the memory die and the memory controller.

The memory controller may share a system bus with the processor die.

The processor die may include a plurality of processor cores, and the memory controller may be connected to the plurality of processor cores via the system bus.

The memory controller may be connected to the system bus based on hybrid bonding.

The processor die may include a first interface circuit, the platform die may include a second interface circuit, the first interface circuit may be configured to serialize data received from the system bus and deserialize data received from the second interface circuit, and the second interface circuit may be configured to serialize data received from the memory controller and deserialize data received from the first interface circuit.

The memory controller may include a bus having a different protocol from the system bus, and the processor die may include a bridge module configured to mediate communication between the bus of the memory controller and the system bus.

The platform die may include a communication module configured to communicate between the processor die and another processor die.

The communication module may share a system bus with the processor die.

The platform die may include a test module.

The platform die may include a voltage regulator.

The platform die may include static random access memory (SRAM), and the SRAM may be configured to operate a cache of the processor die.

The memory die may include a plurality of memory stacks including stacked memory dies, wherein the processor die may include a structure connected to each of the plurality of memory stacks to communicate therewith.

According to another aspect of the disclosure, there is provided a semiconductor package including: a wafer-scale platform chip; and a plurality of memory dies provided on the wafer-scale platform chip; and a plurality of processor dies provided on the wafer-scale platform chip; wherein the wafer-scale platform chip include: a memory controller configured to control data communication between the plurality of memory dies and the plurality of processor dies, and a communication module configured to communicate with the plurality of processor dies.

The memory controller and the communication module share a system bus with the plurality of processor dies.

The memory controller and the communication module may be directly connected to each other in the wafer-scale platform chip.

The wafer-scale platform chip may include an external communication module configured to communicate with a device outside of the wafer-scale platform chip, and the communication module may be connected to the external communication module.

Each of the plurality of memory dies may include a memory stack including stacked memory dies.

Other features and aspects will be apparent from the following detailed description, the drawings, and the claims.

### BRIEF DESCRIPTION OF DRAWINGS

Embodiments of the disclosure will be more clearly understood from the following detailed description taken in conjunction with the accompanying diagrams in which:
FIG. 1 is a perspective view of a related art 2.5D high bandwidth memory (HBM) chiplet structure.
FIG. 2 is a front view of a cross-section of a related art 2.5D HBM chiplet structure for illustrating a data transmission scheme in the related art 2.5D HBM chiplet structure.
FIG. 3 is a front view of a cross-section of a related art 2.5D HBM chiplet structure to provide a description of a data transmission limitation of the related art 2.5D HBM chiplet structure.
FIG. 4 is a top view of a cross-section of a related art 2.5D HBM chiplet structure for illustrating a data transmission limitation occurring in the related art 2.5D HBM chiplet structure.
FIG. 5 is a perspective view of a semiconductor package structure according to an embodiment.
FIG. 6 is a front perspective view of a semiconductor package for illustrating a system bus structure and a communication module in the semiconductor package according to an embodiment.
FIG. 7 is a diagram illustrating an example of a semiconductor package according to an embodiment.
FIG. 8 is a front view of a cross-section of a semiconductor package structure for illustrating an advantage of the semiconductor package structure according to an embodiment.
FIG. 9 is a diagram illustrating a method of connecting a memory controller to a system bus.
FIG. 10 is a diagram illustrating a method of connecting a memory controller to a system bus using a serializer/deserializer (SerDes) technique.
FIG. 11 is a diagram illustrating a method of using a bridge circuit to resolve a protocol difference between a memory controller and a system bus.
FIG. 12 is a diagram illustrating a structure in which a test module and a voltage adjuster are provided on a platform die 220 in a semiconductor package according to an embodiment.
FIG. 13 is a perspective view of a semiconductor package including a plurality of processor dies according to an embodiment.
FIG. 14 is a front view of a cross-section of a semiconductor package including a plurality of platform dies according to an embodiment.
FIG. 15 is a perspective view of a semiconductor package in which four memory stacks are connected to one processor die according to an embodiment.
FIG. 16 is a perspective view of a semiconductor package in which a plurality of processor dies and a memory stack are provided on a wafer according to an embodiment.
FIG. 17 is a front view of a cross-section of a semiconductor package according to an embodiment.
FIGS. 18 and 19 are diagrams illustrating a structure in which a processor die and a system bus are shared with a memory controller and a network on chip (NoC) communication module in a semiconductor package according to an embodiment.
FIG. 20 is a perspective view of a semiconductor package 600 to which a wafer scale platform is applied according to an embodiment.
FIG. 21 is a diagram illustrating a structure of a semiconductor package according to an embodiment.
FIG. 22 is a diagram illustrating an example of implementing a wafer-based rack structure in a semiconductor package according to an embodiment.
FIG. 23 is a perspective view of a semiconductor package structure according to an embodiment.
FIG. 24 is a perspective front view of a semiconductor package to describe a system bus structure and a communication module in the semiconductor package according to an embodiment.
FIG. 25 is a perspective view of a semiconductor package in which a plurality of processor dies and a memory die are provided on a wafer-scale platform chip according to an embodiment.
FIG. 26 is a cross-sectional front view of a semiconductor package according to an embodiment.

Throughout the drawings and the detailed description, unless otherwise described or provided, the same drawing reference numerals will be understood to refer to the same elements, features, and structures. The drawings may not be to scale, and the relative size, proportions, and depiction of elements in the drawings may be exaggerated for clarity, illustration, and convenience.

### DETAILED DESCRIPTION

The following structural or functional descriptions of examples disclosed in the present disclosure are merely intended for the purpose of describing the examples and the examples may be implemented in various forms. The examples are not meant to be limited, but it is intended that various modifications, equivalents, and alternatives are also covered within the scope of the claims.

Although terms of "first" or "second" are used to explain various components, the components are not limited to the terms. These terms should be used only to distinguish one component from another component. For example, a "first" component may be referred to as a "second" component, or similarly, and the "second" component may be referred to as the "first" component within the scope of the right according to the concept of the present disclosure.

It should be noted that if it is described that one component is "connected", "coupled", or "joined" to another component, a third component may be "connected", "coupled", and "joined" between the first and second components, although the first component may be directly connected, coupled, or joined to the second component. On the contrary, it should be noted that if it is described that one component is "directly connected", "directly coupled", or "directly joined" to another component, a third component may be absent. Expressions describing a relationship between components, for example, "between", directly between", or "directly neighboring", etc., should be interpreted to be alike.

The singular forms "a", "an", and "the" are intended to include the plural forms as well, unless the context clearly indicates otherwise. It should be further understood that the terms "comprises" and/or "comprising," when used in this specification, specify the presence of stated features, integers, steps, operations, elements, components or a combination thereof, but do not preclude the presence or addition of one or more other features, integers, steps, operations, elements, components, and/or groups thereof.

According to one or more embodiments, various operations and/or functions described below may be implemented in a hardware approach. For example, according to some embodiments, the methods described below may be implemented by an electronic device configured to carry out a described operation(s) or function(s). The electronic device may include blocks, which may be referred to herein as managers, units, modules, hardware components, "~er" terms or the like, may be physically implemented by analog and/or digital circuits such as logic gates, integrated circuits, microprocessors, microcontrollers, memory circuits, passive electronic components, active electronic components, optical components, hardwired circuits and the like, and may optionally be driven by a firmware. The circuits may, for example, be embodied in one or more semiconductor chips, or on substrate supports such as printed circuit boards and the like. The circuits constituting a block may be implemented by dedicated hardware, or by a processor (e.g., one or more programmed microprocessors and associated circuitry), or by a combination of dedicated hardware to perform some functions of the block and a processor to perform other functions of the block. Each block of the embodiments may be physically separated into two or more interacting and discrete blocks without departing from the scope of the disclosure. Likewise, the blocks of the embodiments may be physically combined into more complex blocks without departing from the scope of the disclosure. However, the disclosure is not limited thereto, and as such, the blocks, which may be referred to herein as managers, units, modules, or the like, may be software modules implemented by software codes, program codes, software instructions, or the like. The software modules may be executed on one or more processors. According to an embodiment, the "module" may be a minimum unit of an integrally formed component or part thereof. The "module" may be a minimum unit for performing one or more functions or part thereof. The "module" may be implemented mechanically or electronically.

Unless otherwise defined, all terms used herein including technical or scientific terms have the same meaning as commonly understood by one of ordinary skill in the art to which examples belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

The examples may be implemented as various types of products, such as, for example, a personal computer (PC), a laptop computer, a tablet computer, a smart phone, a television (TV), a smart home appliance, an intelligent vehicle, a kiosk, and a wearable device. Hereinafter, examples will be described in detail with reference to the accompanying drawings. In the drawings, like reference numerals are used for like elements.

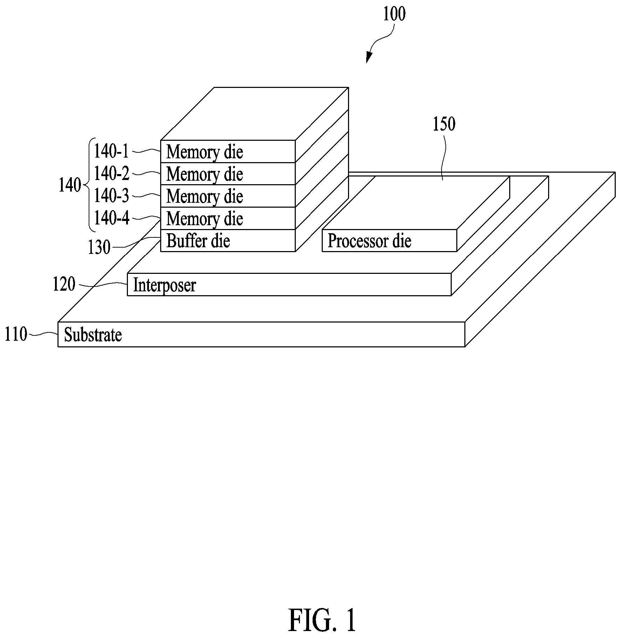

FIG. 1 is a perspective view of a related art 2.5D high bandwidth memory (HBM) chiplet structure.

Referring to FIG. 1, a related art 2.5D HBM chiplet 100 may include a substrate 110, an interposer 120, a buffer die 130, a memory stack 140, and a processor die 150. The memory stack 140 may include memory dies 140-1, 140-2, 140-3, and 140-4. The interposer 120 may be provided on the substrate 110, the buffer die 130 may be provided on the interposer 120, and the memory dies 140-1, 140-2, 140-3, and 140-4 may be stacked on the buffer die 130. The processor die 150 may be provided adjacent to the memory die on the interposer 120.

The interposer 120 of the related art 2.5D HBM chiplet 100 may be a passive component for providing an electrical connection and may provide a physical conducting wire path for communication between a memory die and a processor die. That is, the interposer 120 may simply serve to deliver an electrical signal and may not include any active circuit.

The memory stack 140 may include multiple layers of the memory dies 140-1, 140-2, 140-3, and 140-4 and each of the memory dies 140-1, 140-2, 140-3, and 140-4 may serve to store data and transmit the data to the processor die 150 through the buffer die 130.

In the related art 2.5D HBM chiplet 100, the buffer die 130 plays an important role in relaying data transmission between the memory stack 140 and the processor die 150. The data generated by the memory dies 140-1, 140-2, 140-3, and 140-4 may not be directly transmitted to the processor die 150 and may be transmitted to the processor die 150 via the buffer die 130. In this manner, the buffer die 130 may improve the stability and accuracy of a signal by temporarily storing a data signal and transmitting the signal by regenerating the signal. In addition, the buffer die 130 may serve to improve the data processing speed of an entire system by minimizing latency and signal distortion that may occur during the data transmission process. The buffer die 130 may be referred to as a base die.

The presence of the buffer die 130 may be particularly important in a high-speed data transmission environment because as a physical distance between the memory stack 140 and the processor die 150 increases, signal loss and latency may increase. The buffer die 130 may mitigate the problem described above and may help smoother communication between the memory and the processor. Accordingly, the buffer die 130 may play a pivotal role in maintaining the reliability of data transmission in the related art 2.5D HBM chiplet 100 structure and maximizing the system performance.

The processor die 150 may process the data transmitted from the memory stack 140 and may include various processor cores, such as a central processing unit (CPU), a graphics processing unit (CPU), and a neural processing unit (NPU). The processor cores may be designed to efficiently perform high-performance computational tasks and may smoothly process the data transmission with the memory stack 140.

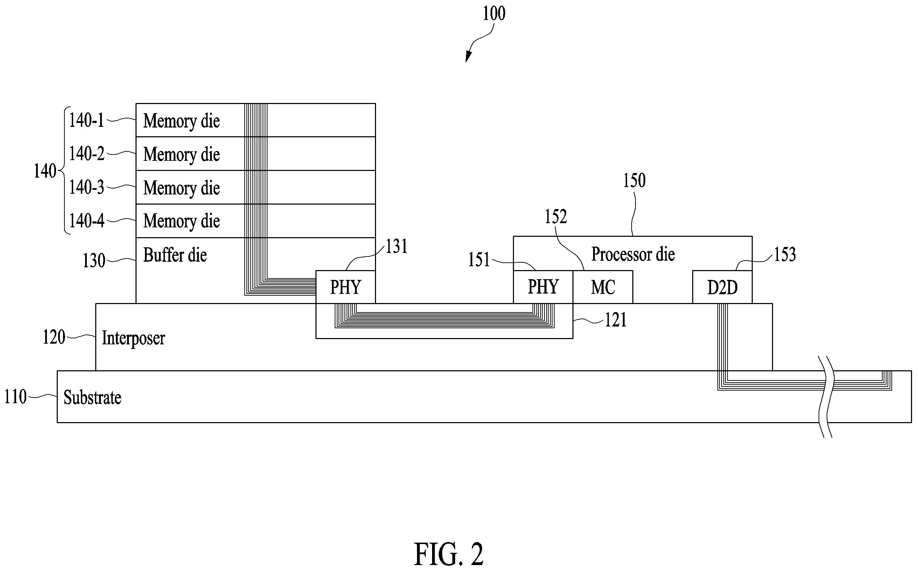

FIG. 2 is a front view of a cross-section of a related art 2.5D HBM chiplet structure for illustrating a data transmission scheme in the related art 2.5D HBM chiplet structure. The description provided with reference to FIG. 1 may also apply to FIG. 2.

Referring to FIG. 2, in the related art 2.5D HBM chiplet 100 structure, since the memory stack 140 and the processor die 150 are physically apart from each other (e.g., less than or equal to 2 mm), electrical loss may occur when transmitting a signal. To compensate for this, physical layer (PHY) circuits 131 and 151 may be required for the buffer die 130 and the processor die 150, respectively, and the PHY circuits 131 and 151 may serve to maintain the accuracy and stability of the signal.

The data generated by the memory stack 140 may pass through the buffer die 130 and may be transmitted to the processor die 150 through the PHY circuit 131 included in the buffer die 130. Also, the PHY circuit 151 may be included in the processor die 150 and a signal transmitted from the memory stack 140 may be processed through the PHY circuit 151.

In the processor die 150, a memory controller (MC) 152 configured to process data from the memory stack 140 and a die-to-die (D2D) communication module 153 configured to communicate with other chips may be installed. The MC 152 may manage data transmission with the memory stack 140 and the communication module 153 may serve to exchange data between the processor die 150 and other chips.

A silicon bridge 121 may be used for a more efficient electrical connection between the memory stack 140 and the processor die 150. Since the silicon bridge 121 has high conducting wire density, the silicon bridge 121 may serve to reduce a signal loss that may occur during the data transmission and may improve a transmission rate. In another example, the data transmission may be performed through the interposer 120 without using the silicon bridge 121, in which case, the interposer 120 may be a passive component to provide a simple electrical conducting wire and may not perform an active signal processing function. However, in this case, a possibility of occurrence of signal loss or distortion in the signal transmission between the memory stack 140 and the processor die 150 may increase. To resolve this problem, the silicon bridge 121 and the PHY circuits 131 and 151 may be required in the related art 2.5D HBM chiplet 100 structure.

However, several disadvantages may be caused by using the PHY circuits 131 and 151. For example, the PHY circuits 131 and 151 may cause additional power consumption and signal latency to process the physical transmission of a signal. Moreover, the PHY circuits 131 and 151 may need to be provided on a shore line, which is an edge of the buffer die 130 and the processor die 150, to physically connect at the shortest distance. This may restrict an available space in the processor die 150 and particularly, since the MC 152 and the communication module 153 may need to be provided in the processor die 150, an available space of the processor die 150 may be even more limited. The limitation may increase the design complexity of the processor die 150 and may restrict a final data rate.

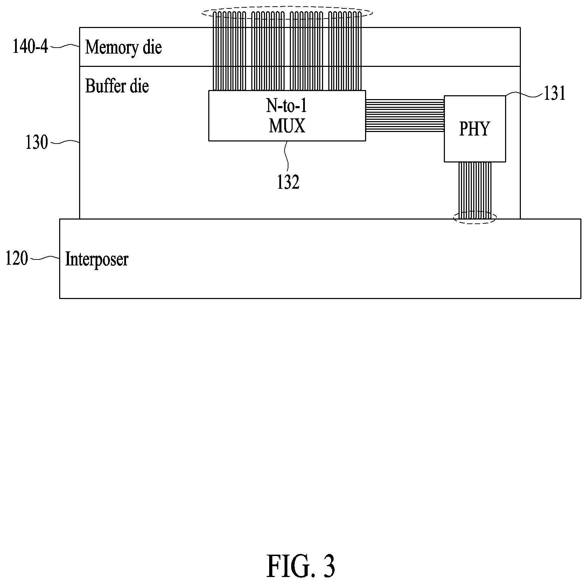

FIG. 3 is a front view of a cross-section of a related art 2.5D HBM chiplet structure for illustrating a data transmission limitation of the related art 2.5D HBM chiplet structure. The description provided with reference to FIGS. 1 and 2 may also apply to FIG. 3.

Referring to FIG. 3, since the interposer 120 only serves as a simple conducting wire, signal loss and distortion may occur in a signal transmission process between the memory stack 140 and the processor die 150. To compensate for the signal loss and/or signal distortion, the PHY circuits 131 and 151 may be required for the HBM memory stack 140 and the processor die 150, respectively.

In this case, the PHY circuit 131 and 151 may need to be connected to the memory stack 140 and the processor die 150 at the shortest distance to minimize the signal loss and distortion. As such, the PHY circuits 131 and 151 may be provided at the closest position to each other. In other words, the PHY circuits 131 and 151 may be provided at a boundary corresponding to the edge of the buffer die 130 and the processor die 150. The interposer 120 and the silicon bridge 121 may need to provide as many conducting wires as possible in a physical space and in this process, an interval between wires (e.g., a pitch size) may be an important factor. However, since the pitch size is limited, it may be impossible to connect all data lines provided by the memory stack 140 to the provided die 150 and only some of the data lines may be used.

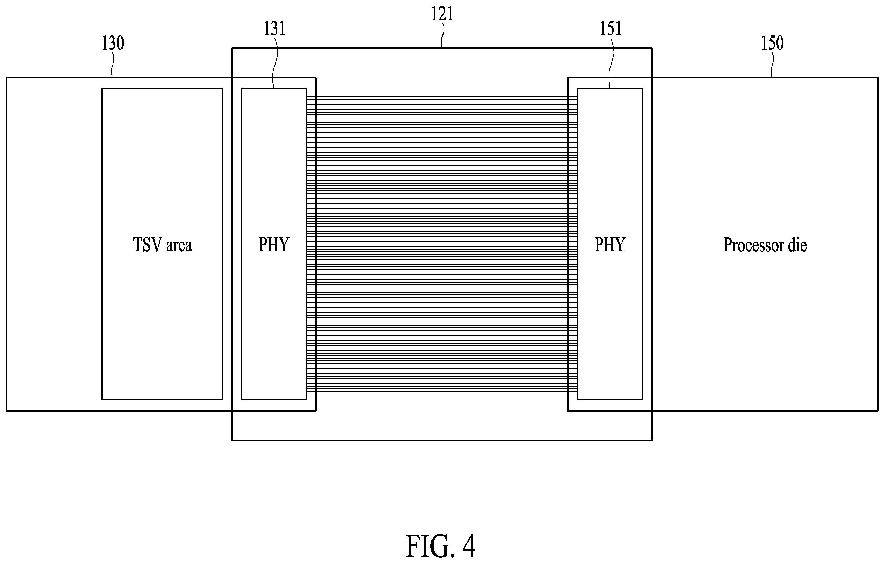

FIG. 4 is a top view of a cross-section of a related art 2.5D HBM chiplet structure for illustrating a data transmission limitation occurring in the related art 2.5D HBM chiplet structure. The description provided with reference to FIGS. 1 to 3 may also apply to FIG. 4.

As described above with reference to FIG. 3, it may be impossible to connect all data lines provided by the memory stack 140 to the processor die 150 due to a physical limitation of the 2.5D HBM chiplet structure and only some of the data lines may be used.

Referring to FIG. 3, the buffer die 130 may transfer some of the data lines provided by the memory stack 140 to the PHY circuit 131 through a multiplexer 132. For example, the multiplexer 132 may be an N:1 multiplexer (e.g., N is 2, 4, or 8) and the multiplexer 132 may transfer 1/N of the data lines provided by the memory stack 140 to the PHY circuit 131. This may result in insufficient utilization of a high bandwidth of the memory and thereby, the performance of the entire system may be degraded. As illustrated in FIG. 4, the buffer die 130 may include a through-silicon via (TSV) area.

As described below, a semiconductor package according to an embodiment may use a platform die including an active circuit instead of an interposer to remove the buffer die 130 required by the related art 2.5D HBM chiplet 100 structure and may implement the role performed by the buffer die 130 in the platform die. Additionally, since a memory controller (MC) is provided on the platform die rather than on the processor die, the PHY circuits 131 and 151 may not be needed. As the active circuit of the platform die performs the role of the PHY circuits 131 and 151, the physical limitation due to the PHY circuits 131 and 151, for example, the problem of the impossibility of connecting all data lines provided by the memory stack 140 to the processor die 150, may be naturally resolved by removing the PHY circuits 131 and 151. Through the structural improvement by adopting the platform die according to an embodiment, the system performance may be improved and a method of connecting an MC to a processor die may be proposed to implement the structure. Hereinafter, a semiconductor package may be a physical structure in which a semiconductor chip is preferably attached to a substrate and is connected to an external circuit. The semiconductor package may also be referred to as a semiconductor structure or a semiconductor device.

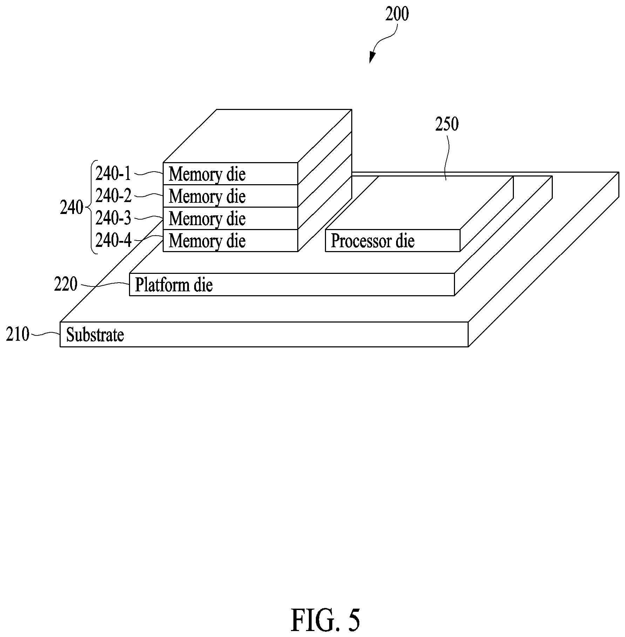

FIG. 5 is a perspective view of a semiconductor package structure according to an embodiment.

Referring to FIG. 5, a semiconductor package 200 according to an embodiment may include a platform die 220 provided on a substrate 210. Unlike the interposer 120 of the related art 2.5D HBM chiplet structure, the platform die 220 may include an active circuit. For example, the platform die 220 may be configured to function as a buffer die. According to an embodiment, main circuits, such as a memory controller (MC), may be provided on the platform die 220. A memory die may be provided on the platform die 220. The memory die may include a memory stack in which a plurality of memory dies are stacked. Although FIGS. 5 to 22 illustrate that the memory die is a memory stack 240, the memory die is not limited thereto, and as such, the memory die may be implemented by various memory devices. For example, the memory die may be implemented by a volatile memory device or a non-volatile memory device. The volatile memory device may be implemented by dynamic random access memory (DRAM), static RAM (SRAM), thyristor RAM (T-RAM), zero capacitor RAM (Z-RAM), or twin transistor RAM (TTRAM). The non-volatile memory device may be implemented by electrically erasable programmable read-only memory (EEPROM), flash memory, magnetic RAM (MRAM), spin-transfer torque MRAM (STT-MRAM), conductive bridging RAM (CBRAM), ferroelectric RAM (FeRAM), phase change RAM (PRAM), resistive RAM (RRAM), nanotube RRAM, polymer RAM (PoRAM), nano floating gate memory (NFGM), holographic memory, a molecular electronic memory device, or insulator resistance change memory. The types of the memory die are not limited thereto.

The memory stack 240 may be provided on the platform die 220 and the memory stack 240 may include a plurality of memory dies 240-1, 240-2, 240-3, and 240-4. For example, the memory dies may be implemented as a HBM and may provide a high data transmission rate and bandwidth. However, the memory stack 240 is not limited thereto. The memory stack 240 may be implemented as a low-power double data rate (LPDDR) device, a graphics double data rate (GDDR) device, or a double data rate (DDR) device in addition to the HBM device.

The platform die 220 may be a type of a semiconductor chip, may be implemented as a semiconductor device, such as silicon, and may be referred to as an active interposer. Unlike the related art interposer 120, the platform die 220 may include an active circuit and main circuits, such as an MC, may be provided on the platform die. The platform die 220 may manage and optimize data transmission between the memory stack 240 and the processor die 250.

According to an embodiment, since a memory controller (MC) is provided on the platform die 220, the data transmission between the memory stack 240 and the processor die 250 may be efficiently managed. The processor die 250 may be directly connected to the MC provided on the platform die 220. Accordingly, a PHY circuit of the related art 2.5D HBM chiplet structure may not be required. Also, limitations due to the PHY circuit, for example, signal loss or distortion, power consumption, and signal latency problems may be naturally resolved as the PHY circuit is not required.

The processor die 250 may include various types of processors, such as a CPU, a GPU, and an NPU. For example, the various types of processors may allow a high-performance computational task, such as a machine learning task including artificial intelligence (AI) and a deep neural network (DNN), to be efficiently performed. A computing system including the semiconductor package 200 may perform various high-performance computational tasks including machine learning. The machine learning may be used for various application fields, such as data analysis, image processing, and natural language processing in addition to the AI and DNN.

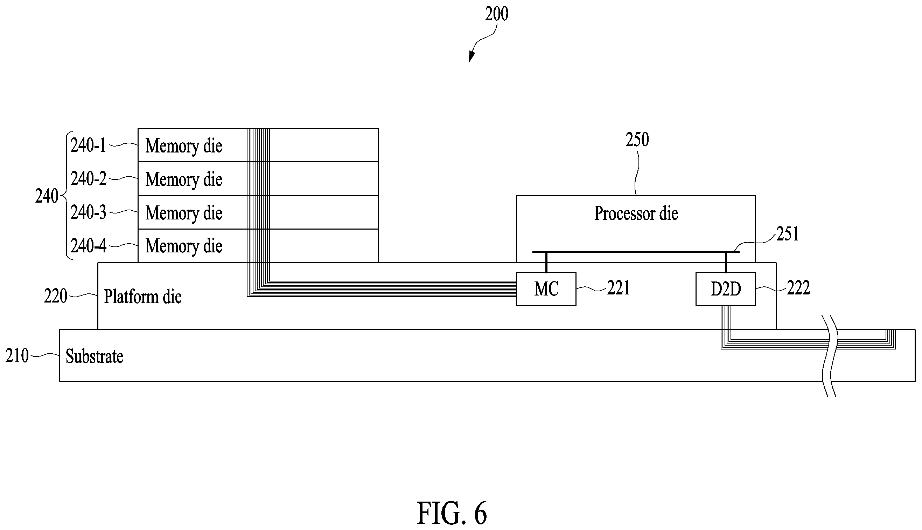

FIG. 6 is a front perspective view of a semiconductor package for illustrating a system bus structure and a communication module in the semiconductor package according to an embodiment. The description provided with reference to FIG. 5 may also apply to FIG. 6.

Referring to FIG. 6, a system bus 251 in the semiconductor package 200 according to an embodiment may manage data transmission between the processor die 250 and the platform die 220. The system bus 251 may also be referred to as an on-chip bus (or an on-chip network) and may support communication among various processor cores. The system bus 251 may use an advanced microcontroller bus architecture (AMBA) advanced extensible interface (AXI) bus as the system bus 251. The AMBA AXI may be a bus that provides high bandwidth and low latency and may enable high-speed data transmission between a slave device and a plurality of masters. However, the system bus 251 is not limited thereto. As such, according to another embodiment, an architecture and/or a protocol of the system bus may be different that AMBA AXI.

The processor die 250 may include a plurality of processor cores (e.g., a CPU, a GPU, and an NPU), and the cores may be connected to each other via the system bus 251. This structure may support the processor cores to efficiently communicate with the MC 221 and other important circuits. For example, the CPU may perform a task of reading or writing data in the memory stack 240 through the MC 221 and the task may be rapidly performed via the system bus 251.

The semiconductor package 200 may also include a communication module 222. The communication module 222 may serve to manage data transmission between the processor die 250 and other processor dies. The communication module 222 may include a die-to-die (D2D) communication module or a chip-to-chip (C2C) communication module. The communication module may use a standard interface, for example, universal chiplet interconnect express (UCIe) or peripheral component interconnect express (PCIe). For example, the D2D communication module may use a UCIe standard interface and the C2C communication module may use a PCIe standard interface. The UCIe may be a latest interface standard for high-speed data transmission between chiplets and may enable efficient communication in a chiplet-based design. The UCIe may provide low latency and a high data processing throughput required for a high-performance computing environment. The PCIe may be a widely used high-speed data transmission interface and may support data transmission between internal and external devices of a computer. The PCIe may significantly improve a data transmission rate using a serial communication scheme and may provide scalability and flexibility by adjusting the number of links.

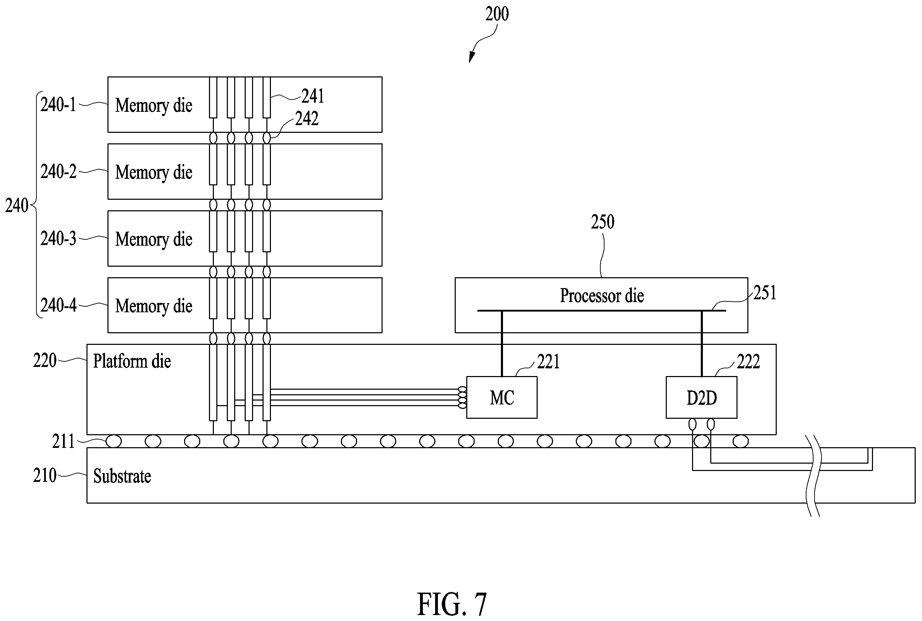

FIG. 7 is a diagram illustrating an example of a semiconductor package according to an embodiment. The description provided with reference to FIGS. 5 and 6 may also apply to FIG. 7.

Referring to FIG. 7, according to an embodiment, each memory die (240-1 to 240-4) of the memory stack 240 may be physically connected to the platform die 220 via a through via 241. The through via 241 may transmit an electrical signal by vertically penetrating the inside of the memory die and may efficiently transmit the data of the memory stack 240 to the platform die 220. Data lines of the memory dies 240-1, 240-2, 240-3, and 240-4 may be connected to the platform die 220 as the data lines are drawn to the platform die 220 by using the through via 241. The through via 241 may be a through-silicon via (TSV) that penetrates a silicon substrate. The TSV may provide a high-speed path for rapidly transmitting the data generated by the memory stack 240 to the platform die 220 without data loss and may maintain signal integrity in the package.

For example, the electrical connection between the memory stack 240 and the platform die 220 may vary depending on a direction in which a wiring layer of the platform die 220 is provided. An active area of the platform die 220 may be formed beneath a surface of a wafer in which active components, such as a transistor, are provided and may perform data operations and processing. A wiring layer area (a back end of the line (BEOL) area) formed above the active area may include multiple layers of metal wires and may serve to transmit a signal generated in the active area.

In an example case in which the wiring layer of the platform die 220 is provided on an upper side (for example, a face-to-face connection or a front-to-front connection), the wiring layer area of the platform die 220 may be in a direct contact with a wiring layer area of the memory stack 240 and may be connected to the wiring layer area of the memory stack 240 as the wiring layer area of the platform 220 is provided on an upper part. In this case, the platform die 220 may be connected to an external circuit by forming the through via 241 in a lower part to be connected to the outside.

In an example case in which the wiring layer of the platform die 220 provided on a lower side (for example, a face-to-back connection or a front-to-back connection), the wiring layer area of the platform die 220 may be provided on the lower part and may not be directly connected to the memory stack 240. In this case, the through via 241 may penetrate the platform die 220 and may be connected to the memory stack 240 in the upper part. A signal generated in the memory stack 240 may be transmitted to the wiring layer area of the platform die 220 via the through via 241 and the wiring layer of the lower part of the platform die 220 may be directly connected to the external circuit without the through via 241.

The electrical connection between the memory stack 240 and the platform die 220 may be made with not only the through via 241 but also with a micro bump 242. The micro bump 242 may provide a contact between the memory stack 240 and the platform die 220 and may ensure a stable transfer of a data signal. The data signal transferred through the micro bump 242 may be directly connected to the MC 221 in the platform die 220 and as such, a data transmission path may be simplified and signal latency may be minimized. However, the disclosure is not limited thereto, and as such, the micro bump 242 is merely an example of a data pin and other types of data pins may be used. For example, other bumps, such as a copper (Cu) bump or a solder bump, may be used as a pin for data transmission. According to another embodiment, a hybrid bonding scheme in which a die is directly connected to a die may be used. According to an embodiment, a solder bump 211 may be provided between the substrate 210 and the platform die 220. The solder bump 211 may be provided to facilitate an interconnection between wirings in the platform die 220 and wirings in the substrate 210.

For example, in the semiconductor package 200, as the data line of the memory stack 240 is directly connected to the platform die 220, the need for a PHY circuit in the related art structure may be eliminated. Since the data may be rapidly and efficiently processed by directly connecting the data line to the MC 221, the data transmission rate may be improved and the overall performance of the system may be optimized. The design may be particularly advantageous in high-performance computing and memory-intensive application fields.

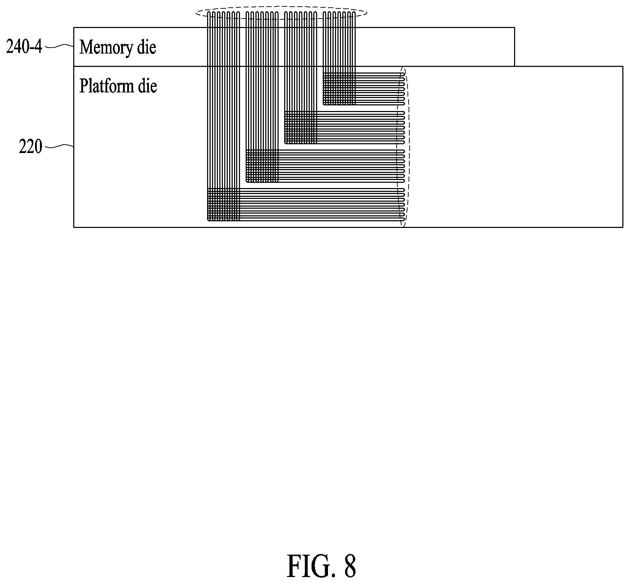

FIG. 8 is a front view of a cross-section of a semiconductor package structure for illustrating an advantage of the semiconductor package structure according to an embodiment. The description provided with reference to FIGS. 5 to 7 may also apply to FIG. 8.

According to an embodiment, the semiconductor package 200 structure may include the platform die 220 having an active circuit. As such, a data line may be directly connected to the MC 221, a data transmission path may be simplified and signal latency and loss may be minimized. The data lines provided by the memory stack 240 may be directly connected to the platform die 220 and the data transmission rate and system performance may be improved.

For example, since the platform die 220 may directly receive the data line of the memory stack 240, a bottleneck phenomenon occurring during the data transmission process may be removed. For example, the data line provided by the memory stack 240 may be directly connected to the platform die 220, and thereby, the data transmission rate may be improved. This structural advantage may play an important role in high-performance operations and large volume of data processing.

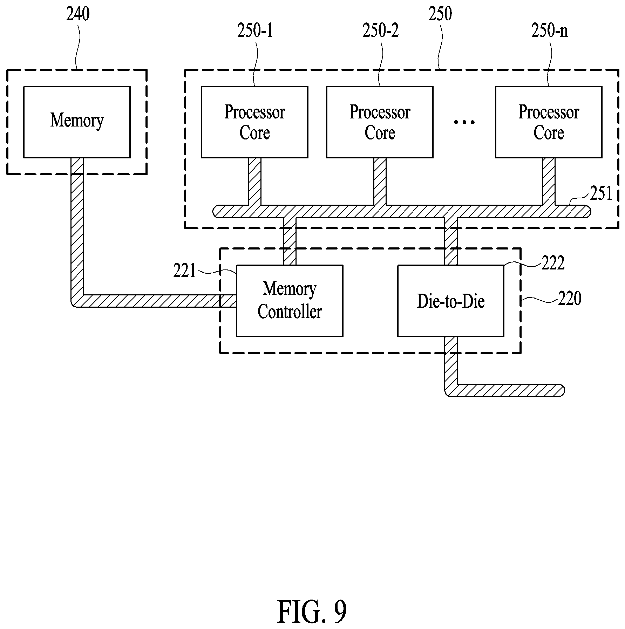

The semiconductor package 200 according to an embodiment may secure a free space in the processor die 250 and may dispose, in the space, an additional core or a module for performance improvement by providing the MC 221 on the platform die 220 rather than on the processor die 250. However, since the memory speed may be significantly faster than the speed of the system bus 251, many data lines may be required for a data transmission path between the MC 221 and the system bus 251. Hereinafter, a method of efficiently resolving the problem described above is described with reference to FIGS. 9 to 11.

FIG. 9 is a diagram illustrating a method of connecting a memory controller to a system bus. The description provided with reference to FIGS. 5 to 8 may also apply to FIG. 9.

Referring to FIG. 9, the processor die 250 may include a plurality of processor cores and the processor cores may be connected to the system bus 251 to exchange data. For example, the processor die 250 may include processor cores 250-1 to 250-n, where n is a natural number greater than or equal to 2.

Multiple data lines may be connected between the MC 221 to the system bus 251 to rapidly transfer the data generated by the MC 221 to the system bus 251. For example, the multiple data lines may be directly connected between the MC 221 to the system bus 251. According to an embodiment, a hybrid bonding technique may be used for facilitating data transmission between the MC 221 and the system bus 251. For example, the hybrid bonding technique is a method of providing data lines at high density in a die-to-die connection and may physically extend a data transmission path between the MC 221 and the system bus 251. This may improve the data transmission rate and may minimize latency.

In addition, the communication module 222 may be connected to the system bus 251 in a similar manner to the MC 221, and thereby, efficient data transmission with other processor dies may be enabled.

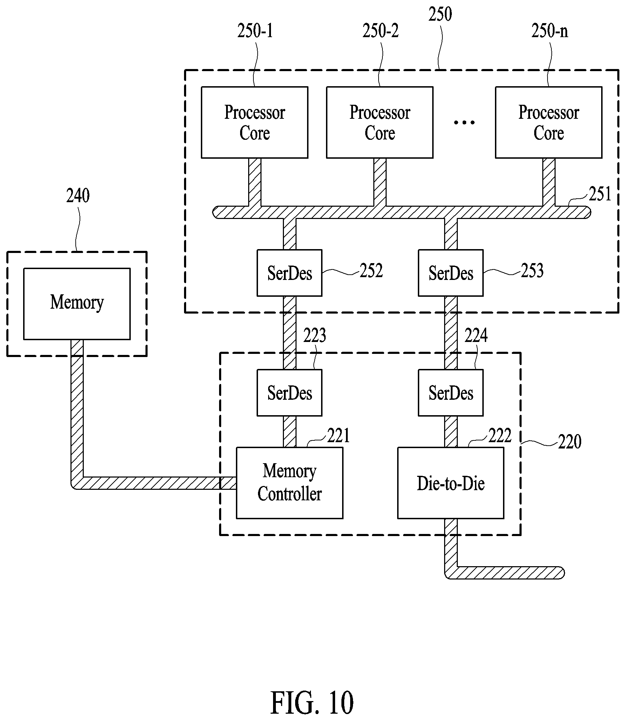

FIG. 10 is a diagram illustrating a method of connecting a memory controller to a system bus using a serializer/deserializer (SerDes) technique. The description provided with reference to FIGS. 5 to 8 may also apply to FIG. 10.

Referring to FIG. 10, the semiconductor package 200 according to an embodiment may include SerDes circuits 252 and 223 to efficiently transmit data read by the memory die to the system bus 251 via the MC 221 or to transmit data from the system bus 251 to the memory die via the MC 221. For example, SerDes may be a technique for converting (serializing) parallel data into serial data and restoring (deserializing) the serial data to the parallel data. The semiconductor package 200 may reduce the number of data lines using the SerDes circuits 252 and 223 while maintaining the high data transmission rate.

The SerDes circuit 223 may serve to perform data transmission between the MC 221 and the system bus 251. In an example case in which the data read by the memory die may be transmitted to the SerDes circuit 223 via the MC 221 and may be serialized. The serialized data may be transmitted to the system bus 251 and the data reaching the system bus 251 may be deserialized through the SerDes circuit 252 and may be transmitted to the plurality of processor cores 250-1 to 250-n of the processor dies 250. In an example case in which the data is transmitted from the system bus 251 to the MC 221, the SerDes circuit 252 may serialize and transmit the data and the SerDes circuit 223 may deserialize and transmit to the MC 221. In this process, the SerDes circuit may minimize signal distortion or loss and may maximize the data transmission efficiency. As described above, the MC 221 may perform efficient bidirectional data transmission with the system bus 251 via the SerDes circuits 223 and 252.

In addition, the communication module 222 may also be bidirectionally connected to the system bus 251 via the SerDes circuits 224 and 253.

The data read by another processor die may be transmitted to the SerDes circuit 224 via the communication module 222 and may be serialized. In an example case in which the serialized data may be transmitted to the system bus 251 and the data reaching the system bus 251 may be deserialized via the SerDes circuit 253 and may be transmitted to the plurality of processor cores 250-1 to 250-n of the processor die 250. In an example case in which the data is transmitted from the system bus 251 to another processor die, the SerDes circuit 253 may serialize and transmit the data and the SerDes circuit 224 may deserialize and transmit to the communication module 222. As described above, the communication module 222 may perform efficient bidirectional data transmission with the system bus 251 via the SerDes circuits 224 and 253.

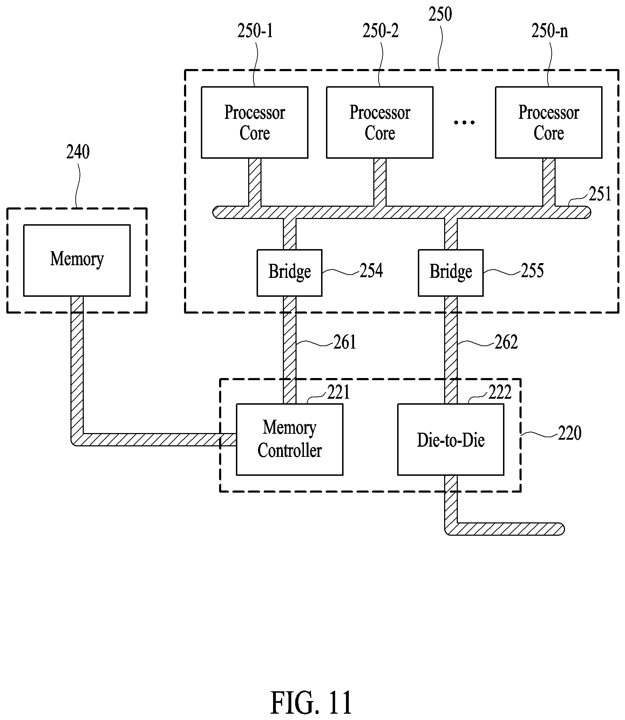

FIG. 11 is a diagram illustrating a method of using a bridge circuit to resolve a protocol difference between a memory controller and a system bus. The description provided with reference to FIGS. 5 to 8 may also apply to FIG. 11.

According to an embodiment, the MC 221 may process data using a unique bus protocol that is different from the system bus 251 and a bridge circuit 254 may be used to make the data compatible with the system bus 251. According to an embodiment, the bridge circuit 254 may also serve to convert the data transmitted from the system bus 251 into a format understandable by the MC 221. For example, the bridge circuit 254 and the MC 221 may be connected via a bus line 261.

The bridge circuit 254 may function as a mediator in converting data between two different protocols between the MC 221 and the system bus 251. For example, the MC 221 may use a specific high-speed memory protocol, whereas the system bus 251 may use a different protocol, such as an AMBA AXI bus. In this case, the bridge circuit 254 may convert the data transmitted from the MC 221 into a format that the system bus 251 is able to understand and conversely, may convert the data transmitted from the system bus 251 into a format that the MC 221 is able to process.

In addition, the communication module 222 may be connected to the system bus 251 via a bridge circuit 255. According to an embodiment, the communication module 222 may use a unique protocol when transmitting the data with other processor dies. For example, the unique protocol may not be compatible with the system bus 251. In this case, the bridge circuit 255 may convert the data transmitted from the communication module 222 into a format that the system bus 251 is able to understand and conversely, may convert the data transmitted from the system bus 251 into a format that the communication module 222 is able to process to mediate the communication. For example, the bridge circuit 255 and the communication module 222 may be connected to each other via a bus line 262.

According to an embodiment, using the bridge circuits 254 and 255 may allow the MC 221 and the communication module 222 to efficiently communicate with the system bus 251 and may improve the data transmission efficiency of the system while maintaining compatibility between various protocols. This may enable smooth data transmission between the memory and the processor and may optimize the performance of the entire system.

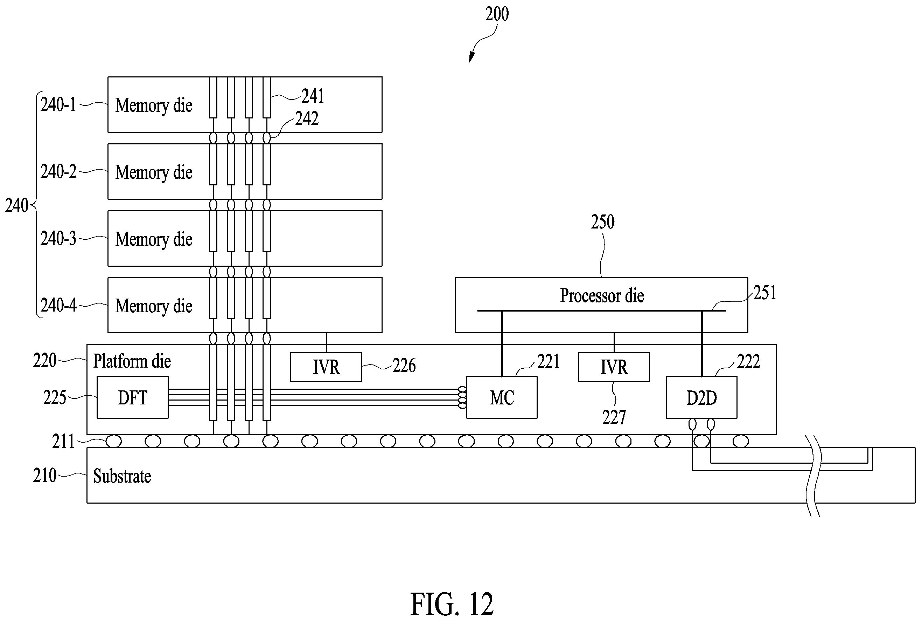

FIG. 12 is a diagram illustrating a structure in which a test module and a voltage adjuster are provided on a platform die 220 in a semiconductor package according to an embodiment. The description provided with reference to FIGS. 5 to 11 may also apply to FIG. 12.

A buffer die of the related art 2.5D HBM chiplet may serve to adjust a signal between a memory stack and an MC. For example, in order to adjust the signal between the memory stack and the MC, various circuits for stabilizing and amplifying a signal may be provided on the buffer die. However, the semiconductor package 200 according to an embodiment may remove the buffer die and simplify the design by integrating the function into the platform die 220. However, the disclosure is not limited thereto, and as such, according to an embodiment, the platform die 220 may include a buffer circuit that may serve to directly adjust data between the memory stack 240 and the MC 221. For example, the buffer circuit of the platform die 220 may buffer signals between the memory stack 240 and the MC 221 to independently maintain the size of each signal. In another example, multiple signals may be transmitted at different speeds and the buffer circuit may serve to chronologically align and send the signals to depart at the same time. In other words, the semiconductor package 200 may minimize signal loss or distortion via the buffer circuit of the platform die 220 and may improve the reliability and speed of data transmission.

Referring to FIG. 12, a test module may be provided on the platform die 220. The test module may be, for example, a design for test (DFT) module 225. The DFT module 225 may perform various functions for testing a semiconductor device and may improve the test efficiency of the entire chip as the DFT module 225 is provided on the platform die 220. For example, the DFT module 225 may test a communication path among the memory stack 240, the MC 221, and the processor die 250 to detect a defect early in a production stage and ensure the reliability of the entire system.

In addition, a voltage regulator may be provided on the platform die 220. The voltage regulator may include, for example, integrated voltage regulator (IVR) modules 226 and 227. The IVR modules 226 and 227 may be circuits playing an important role in adjusting a voltage and optimizing power management. For example, the IVR module 226 may manage the memory stack 240, may stably supply the power required for the memory stack, and/or may adjust a voltage. The IVR module 227 may manage the processor die 250, may adjust a voltage according to the power requirement of the processor die, and/or may ensure an efficient power supply. In a related art method, a power management circuit is physically apart from a memory stack or a processor die, and thereby, the power efficiency may be reduced. However, the semiconductor package 200 may enable power management closely related to the memory stack and the processor die by providing the IVR modules 226 and 227 on the platform die. This may result in reducing the power loss, improving the stability of power supply, and optimizing the power efficiency of the entire system.

According to an embodiment, static random access memory (SRAM) may also be provided on the platform die 220. The SRAM may be used as a cache connected to the processor die 250. The cache may play an important role in increasing a processing rate of a processor by storing data most frequently accessed by processor cores. As the SRAM is provided on the platform die 220, a cache memory may be placed close to the processor die 250, and thereby, access speed may become faster and the overall system performance may be improved.

Although FIG. 12 illustrates that the MC 221 is positioned below the processor die 250, the position of the MC 221 is not limited thereto. For example, the MC 221 may be positioned below the memory stack 240. In addition, the communication module 222 (e.g., D2D 222) may be positioned as close as possible to the boundary of the platform die as possible. In this manner, the communication module 22 may facilitate die-to-die communication with minimum latency, optimize the system performance, and optimize communication with other processor dies.

Through the structural improvement described above, the semiconductor package 200 may simplify the design and may maximize the performance and efficiency of the system by integrating various functions performed by a related art buffer die into the platform die 220.

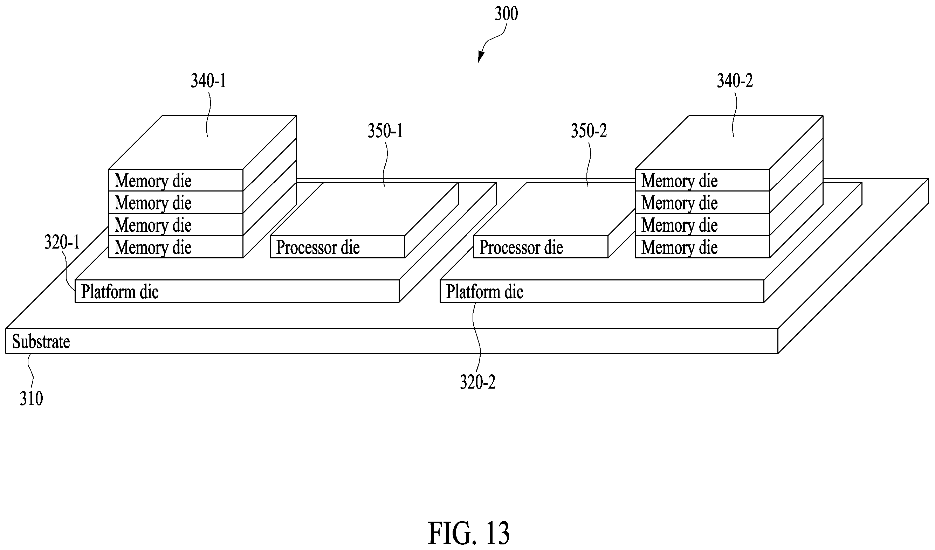

FIG. 13 is a perspective view of a semiconductor package including a plurality of processor dies according to an embodiment. The description provided with reference to FIGS. 5 to 12 may also apply to FIG. 13.

Although FIG. 13 illustrates an example of a semiconductor package 300 including two platform dies 320-1 and 320-2, the semiconductor package 300 is not limited thereto and may include a plurality of platform dies.

Referring to FIG. 13, the semiconductor package 300 according to an embodiment may include two platform dies 320-1 and 320-2 provided on a substrate 310. For example, processor dies 350-1 and 350-2 may be provided on the platform dies 320-1 and 320-2, respectively, and the processor dies may include processor cores, such as a CPU, a GPU, or an NPU. The processor dies 350-1 and 350-2 may serve to perform high-performance operation tasks and data processing and may be interconnected to optimize the system performance.

The platform dies 320-1 and 320-2 may be connected to each other via a communication module. In addition, memory stacks 340-1 and 340-2 may be stacked on the platform dies 320-1 and 320-2, respectively, to store and process data by being directly connected to the respective platform dies. The memory stack may use HBM or other memory techniques.

According to an embodiment of the disclosure, the number of platform dies is not limited to two and a plurality of platform dies may be included, as necessary. As the platform dies are interconnected via a communication module, the scalability and performance of the system may be maximized. This structure may be advantageous to improve the efficiency of parallel processing and high-performance operation tasks.

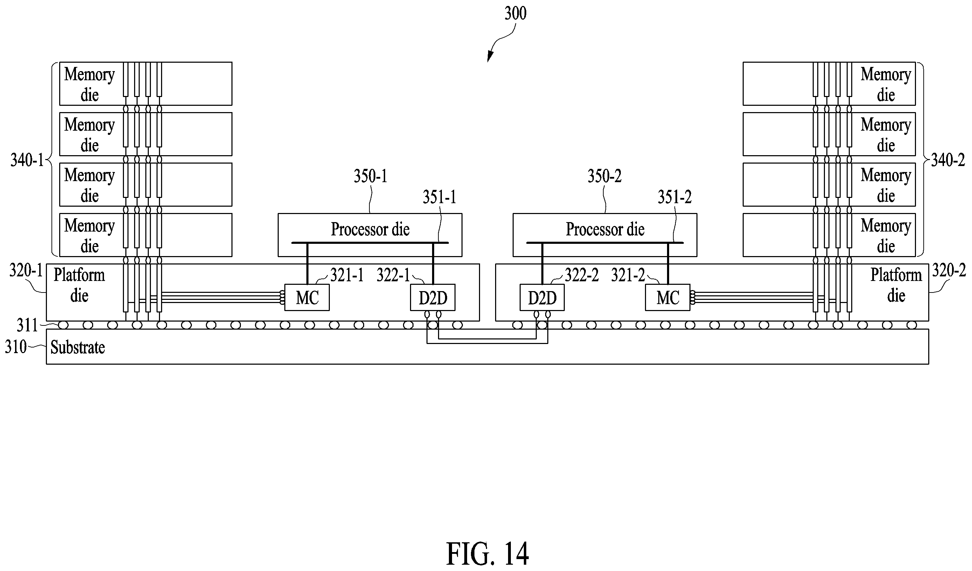

FIG. 14 is a front view of a cross-section of a semiconductor package including a plurality of platform dies according to an embodiment. The description provided with reference to FIGS. 5 to 13 may also apply to FIG. 14.

Referring to FIG. 14, two platform dies 320-1 and 320-2 are provided on the substrate 310 in parallel and the processor dies 350-1 and 350-2 are provided on the platform dies 320-1 and 320-2, respectively.

The substrate 310 may be a basis of a semiconductor package and all components may be fixed thereto. The substrate 310 may provide electrical connection and may serve to transfer power and signals in the package.

The platform dies 320-1 and 320-2 may be provided on a substrate 330 and the processor dies 350-1 and 350-2 may be provided on the platform dies 320-1 and 320-2, respectively. The processor dies 350-1 and 350-2 may include processor cores, such as a CPU, a GPU, or an NPU, and may perform high-performance operations and data processing. The data transmission between the processor dies 350-1 and 350-2 may be performed via communication modules 322-1 and 322-2 provided on the platform dies 320-1 and 320-2, respectively. The communication modules 322-1 and 322-2 may be designed to rapidly and efficiently transmit data between the processor dies 350-1 and 350-2, may minimize latency occurring during the data transmission and may maximize a transmission rate.

The memory stacks 340-1 and 340-2 may be stacked on the platform dies 320-1 and 320-2, respectively, and the memory stack may store and process data. The memory stack 340-1 and 340-2 may use the HBM technique and may be directly connected to the platform dies 320-1 and 320-2 via MCs 321-1 and 321-2, respectively.

The number of platform dies of the semiconductor package 300 according to an embodiment is not limited to two and a plurality of platform dies may be included. The semiconductor package structure described above may maximize the scalability and performance of the system, and particularly, may provide a huge advantage in an environment that requires parallel processing and high-performance operations. As the plurality of platform dies are effectively connected via a communication module, the speed and efficiency of data processing of the entire system may be improved.

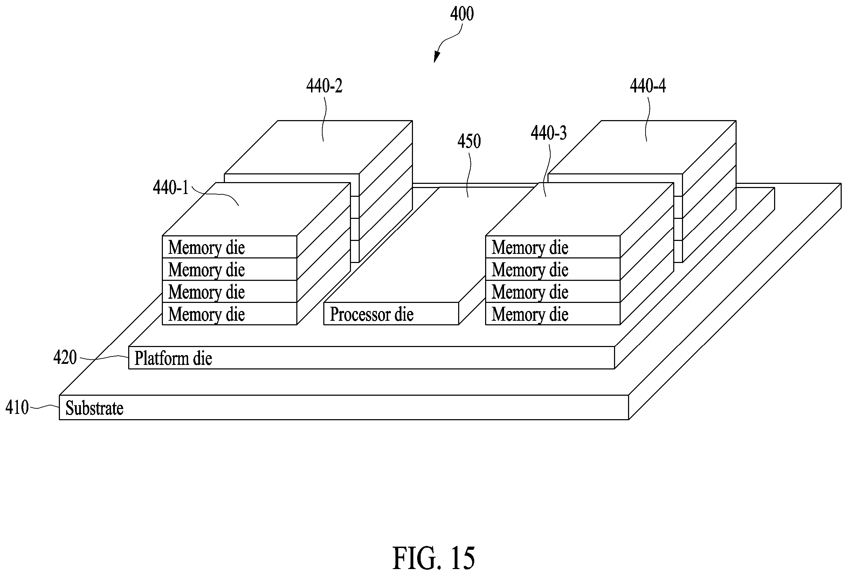

FIG. 15 is a perspective view of a semiconductor package in which four memory stacks are connected to one processor die according to an embodiment. The description provided with reference to FIGS. 5 to 14 may also apply to FIG. 15.

Referring to FIG. 15, a semiconductor package 400 according to an embodiment may include a platform die 420 provided on a substrate 410, a plurality of memory stacks 440-1, 440-2, 440-3, and 440-4 stacked thereon, and a processor die 450 connected to the memory stacks.

According to an embodiment, a memory controller (MC) may be provided on the platform die 420 and the MC may serve to control data communication between the plurality of memory stacks 440-1, 440-2, 440-3, and 440-4 and the processor die 450. The data generated by the memory stacks 440-1, 440-2, 440-3, and 440-4 may pass the MC provided on the platform die 420 and then may be transmitted to the processor die 450. This structure may enable efficient data transmission between a memory and a processor.

The memory stacks 440-1, 440-2, 440-3, and 440-4 may use a memory technique, such as HBM, and each memory stack may serve to store and transmit the data to the processor die 450 via the MC provided on the platform die 420. The number of memory stacks is not limited to four and more memory stacks may be connected to one processor die, as necessary.

The processor die 450 may process the data transmitted from the memory stacks 440-1, 440-2, 440-3, and 440-4. The processor die 450 may include various processor cores, such as a CPU, a GPU, or an NPU, and may perform high-performance operation tasks through efficient connection with the MC.

The semiconductor package 400 according to an embodiment may be advantageous to an application field requiring high-bandwidth data transmission. In an example case in which the plurality of memory stacks is connected to one processor die, each memory stack may efficiently communicate with the processor die via the MC of the platform die. This may allow the maximization of the performance and scalability of the system, and particularly, may provide a significant benefit in parallel data processing and high-performance operation tasks.

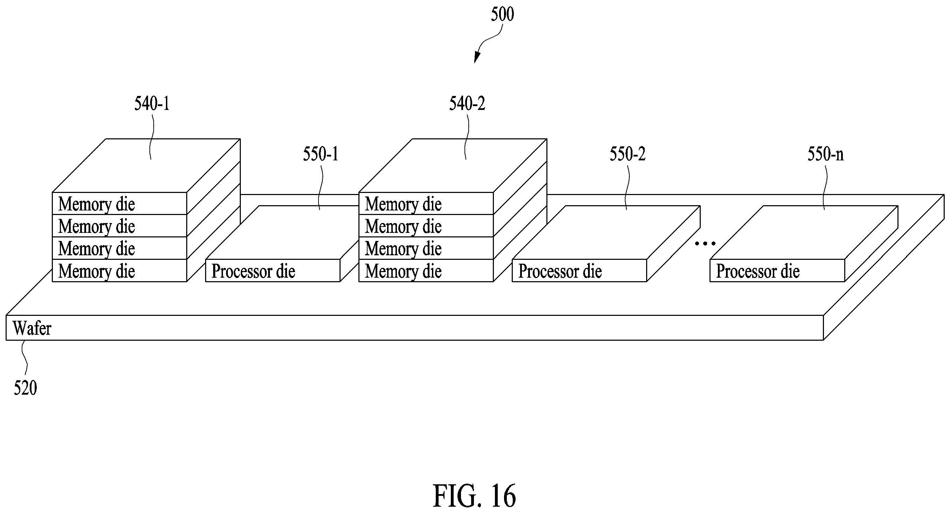

FIG. 16 is a perspective view of a semiconductor package in which a plurality of processor dies and a memory stack are provided on a wafer-scale platform chip according to an embodiment. The description provided with reference to FIGS. 5 to 15 may also apply to FIG. 16.

Referring to FIG. 16, a semiconductor package 500 in a wafer-scale platform structure according to an embodiment may include a wafer-scale platform chip 520. The wafer-scale platform chip 520 may include active circuits and the functions of the platform die described with reference to FIGS. 5 to 15 may be expanded at a wafer level. Since the wafer-scale platform chip 520 of the semiconductor package 500 is wafer-scale, all wirings may be performed on a wafer. Accordingly, the semiconductor package 500 may not require a separate substrate. The wafer-scale platform chip 520 may include active circuits, such as an MC, a network on chip (NoC) communication module, and a wafer-to-wafer (W2W) communication module, and through them, may efficiently manage data communication between a plurality of memory stacks 540-1 and 540-2 and processor dies 550-1 and 550-2. Each of the memory stacks 540-1 and 540-2 may use an HBM technique and may serve to store and transmit data. Although FIG. 16 illustrates an example of the semiconductor package 500 including two memory stacks 540-1 and 540-2, the semiconductor package 500 is not limited thereto.

According to an embodiment, not all processor dies 550-1 to 550-n may be directly connected to a memory stack. Some of the processor dies 550-1 and 550-2 may be directly connected to the memory stacks 540-1 and 540-2 via the MC, but the other processor dies (e.g., 550-n) may perform a separate task without being directly connected to the memory die. In this case, the processor dies (e.g., 550-n) may communicate with other processor dies and memory stacks via the NoC communication module.

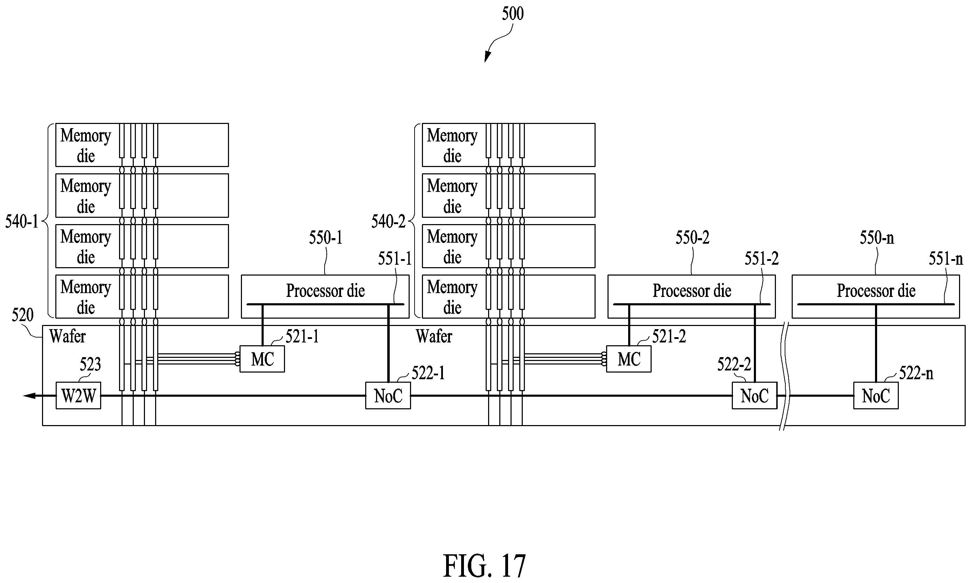

FIG. 17 is a front view of a cross-section of a semiconductor package according to an embodiment. The description provided with reference to FIGS. 5 to 16 may also apply to FIG. 17.

Referring to FIG. 17, the semiconductor package 500 may show a structure in which the plurality of processor dies 550-1 to 550-n and the memory stacks 540-1 and 540-2 are provided on the wafer-scale platform chip 520.

MCs 521-1 and 521-2, NoC communication modules 522-1 to 522-n, and a wafer-to-wafer (W2W) communication module 523 may be provided on the wafer-scale platform chip 520. The MCs 521-1 and 521-2 may manage data communication between the memory stacks 540-1 and 540-2 and the processor dies 550-1 and 550-2, respectively. For example, the processor dies 550-1 and 550-2 may be connected to the MCs 521-1 and 521-2 and the NoC communication modules 522-1 and 522-2, respectively, and the connections may be performed by sharing the same bus, such as system buses 551-1 and 551-2. For example, the processor die 550-1 may be connected to the MC 521-1 and the NoC communication module 522-1 and in this case, the connection may share the system bus 551-1.

However, a processor die (e.g., a processor die 550-n) may not be directly connected to a memory stack as described above and may independently operate. The processor die 550-n may be connected to an NoC communication module 522-n and in this case, the connection may share a system bus 551-n. The processor die (e.g., the processor die 550-n) may communicate with other processor dies and memory stacks via the NoC communication module 522-n connected thereto. The NoC communication module 522-1 to 522-n may support data transmission with the processor dies 550-1 to 550-n in the wafer and may significantly improve the flexibility and scalability of the system. An NoC structure in the wafer-scale platform chip 520 may allow each processor die to transfer the data with other processor dies or memory stacks, as necessary. Thereby, the system may efficiently process a complex operation task and may show optimal performance in various application programs.

In addition, the W2W communication module 523 may support wafer-to-wafer communication and may enable data synchronization and communication with various wafers. Through the W2W communication module 523, the semiconductor package 500 may perform efficient data transmission and cooperative tasks in an expanded system through multiple wafers.

The semiconductor package 500 according to an embodiment may optimize the efficiency of data transmission and may be advantageous to a high-performance computing environment that requires a large volume of parallel operations.

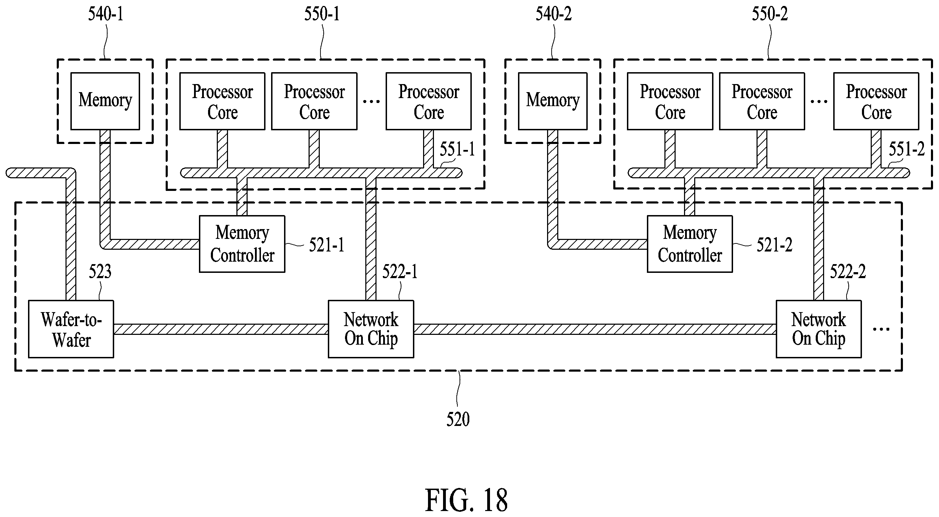

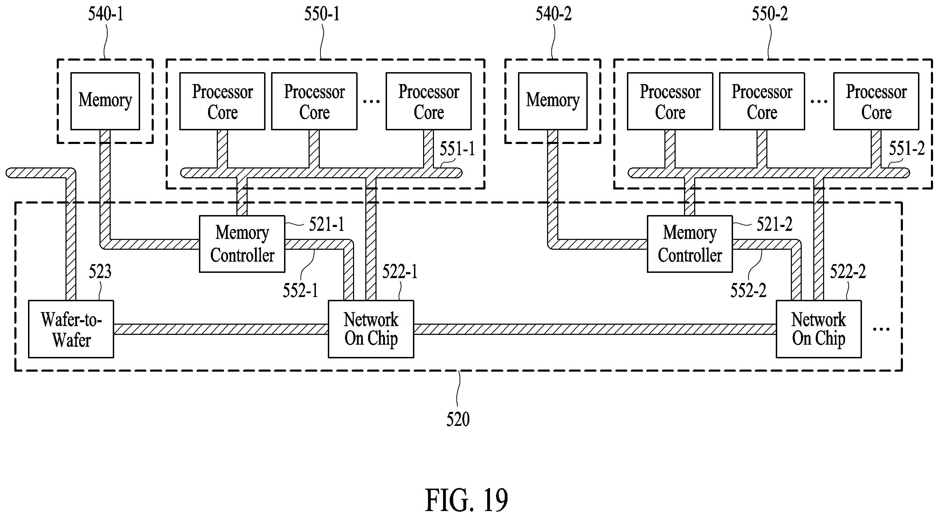

FIGS. 18 and 19 are diagrams illustrating a structure in which a processor die and a system bus are shared with a memory controller and a network on chip (NoC) communication module in a semiconductor package according to an embodiment. The description provided with reference to FIGS. 5 to 17 may also apply to FIGS. 18 and 19.

Referring to FIG. 18, in the semiconductor package 500 according to an embodiment, the MCs 521-1 and 521-2 and the NoC communication modules 522-1 and 522-2 may be connected to the processor dies 550-1 and 550-2 via the system buses 551-1 and 551-2, respectively.

In an example case in which the MCs 521-1 and 521-2 and the NoC communication modules 522-1 and 522-2 are connected to the system buses 551-1 and 551-2, the method of connecting the MC and the communication module to the system bus described with reference to FIGS. 9 to 11 may be applied. For example, in an example case in which the MC 521-1 is connected to the processor die 550-1 via the system bus 551-1, the connection may be performed by directly connecting a data line or serializing or deserializing the data using a SerDes circuit. in addition, communication between different protocols may be mediated by providing a bridge circuit between the MC and the NoC communication module using their own protocol.

In a processor die (e.g., the processor die 550-1) according to an embodiment, to retrieve data from a memory die (e.g., the memory die 540-2) that is not connected to the processor die, the intervention of a processor die (e.g., the processor die 550-2) that is connected to the memory die 540-2 may be required. For example, to retrieve the data from the memory die 540-2 in the processor die 550-1, the processor die 550-1 may access the memory die 540-2 in the order of the NoC communication module 522-1 connected to the processor die 550-1, the NoC communication module 522-2 connected to the memory die 540-2, the processor die 550-2, and the MC 521-2.

Referring to FIG. 19, the MCs 521-1 and 521-2 and the NoC communication modules 522-1 and 522-2 according to an embodiment may be directly connected to each other. The NoC communication modules 522-1 and 522-2 may include a direct memory access (DMA) function. Through this, in a processor die (e.g., the processor die 550-1), in an example case in which the data of a memory die (e.g., the memory die 540-2) that is not connected to the processor die is retrieved, a processor die (e.g., the processor die 550-1) may directly access the MC 521-2 without the intervention of a processor die (e.g., the processor die 550-2) that is connected to the memory die. For example, to retrieve the data from the memory die 540-2 in the processor die 550-1, the processor die 550-1 may access the memory die 540-2 in the order of the NoC communication module 522-1 connected to the processor die 550-1, the NoC communication module 522-2 connected to the memory die 540-2, and the MC 521-2.

According to an embodiment, the direct connection scheme as illustrated in FIGS. 18 and 19 may maximize the efficiency of data transmission in the high-performance computing environment and specifically, may provide a great benefit to a system in which parallel operations are frequently performed. Through the direction connection between the MC and the NoC communication module, a data flow in the system may be optimized and the overall system performance may be improved.

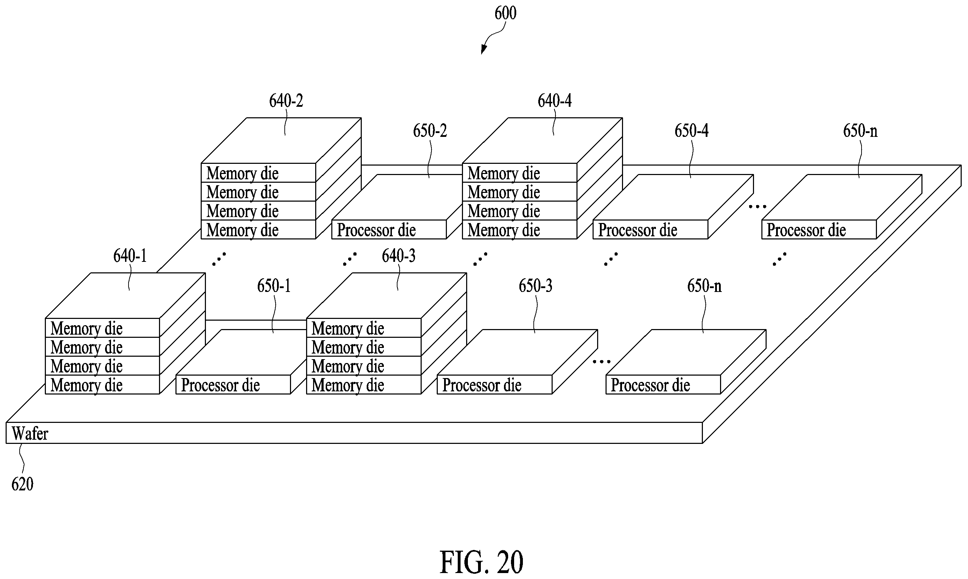

FIG. 20 is a perspective view of a semiconductor package 600 to which a wafer scale platform is applied according to an embodiment.

Referring to FIG. 20, a plurality of memory stacks 640-1 to 640-4 and a plurality of processor dies 650-1 to 650-n may be provided on a wafer 620 of a semiconductor package 600 in an expanded wafer-scale platform structure according to an embodiment.

The wafer-scale platform structure according to an embodiment may be based on a concept of providing as many dies as possible on a single wafer to maximize the performance rather than fabricating a chiplet on a related art reticle-by-reticle basis. The wafer-scale platform structure may enable large-scale die integration using the entire wafer 620. FIG. 16 shows a basic form in which processor dies are arranged in a single line, whereas FIG. 20 more intuitively shows a feature of the wafer-scale platform.

Compared to the semiconductor package 500 described with reference to FIG. 16, the semiconductor package 600 may have a structure in which memory stacks 640-1 to 640-4 and processor dies 650-1 to 650-n are arranged in multiple lines in an expanded form rather than providing memory stacks and processor dies in a single line on the wafer 620. Although FIG. 20 illustrates an example of the semiconductor package 600 including four memory stacks 640-1 to 640-4, the semiconductor package 600 is not limited thereto.

The wafer 620 may include active circuits and may include an MC and an NoC communication module. Similarly, in the semiconductor package 600 of FIG. 20, the plurality of processor dies 650-1 to 650-n may be connected to each other via the NoC communication module. The NoC communication module may transmit the data between processor dies and may control a data flow between dies. Through this NoC structure, the processor dies may transfer the data at high speed and low latency and may maximize the performance of the entire system.

In addition, the MC provided in the wafer 620 may manage the data communication between each memory stack and each processor die and may be connected to a system bus to transfer the data processed by the memory stack to the processor die or transmit the data from the processor die to the memory stack. The MC and the NoC communication module may cooperate with each other to optimize the data transmission and improve the efficiency of the data flow in the system.

The semiconductor package 600 of FIG. 20 having the expanded wafer-scale platform structure may provide excellent performance in the high-performance computing environment as multiple processor dies and memory stacks are simultaneously provided. As the plurality of processor dies 650-1 to 650-n is connected via the NoC communication module, flexible and efficient data processing and high-speed operations may be enabled in the wafer 620. This structure may provide a great benefit to a field that requires parallel processing and big data analysis.

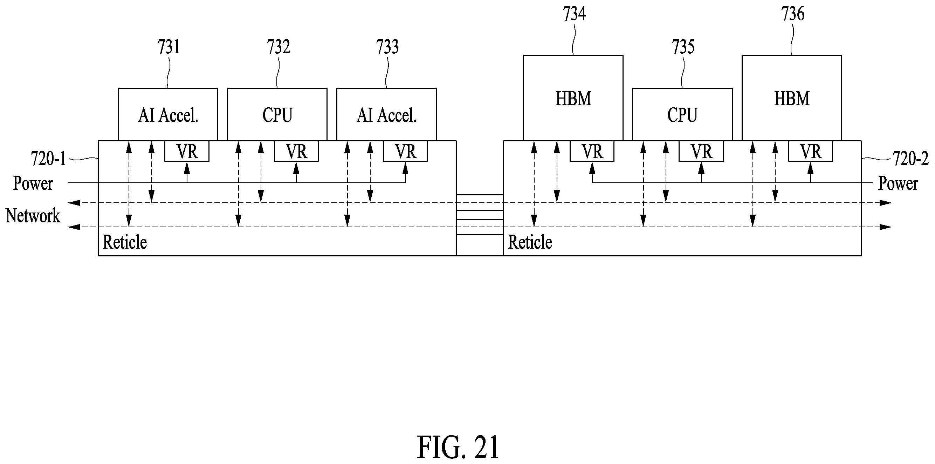

FIG. 21 is a diagram illustrating a structure of a semiconductor package according to an embodiment. The description provided with reference to FIGS. 5 to 20 may also apply to FIG. 21.

Referring to FIG. 21, a semiconductor package 700 according to an embodiment may be a new concept of a semiconductor package to implement large-scale integration beyond a system on chip (SoC), based on a wafer-scale platform.

The semiconductor package 700 may include a plurality of reticles 720-1 and 720-2. The semiconductor package 700 according to an embodiment is an example of the semiconductor package 500 having the wafer-scale platform structure and the plurality of reticles 720-1 and 720-2 may be implemented on a wafer-scale platform chip (e.g., the wafer-scale platform chip 520 of FIG. 16D). The plurality of reticles 720-1 and 720-2 may be implemented on one wafer and may be connected to each other rather than being physically cut.

A plurality of AI accelerators 731 and 733 and a processor die 732 may be provided on the reticle 720-1. A plurality of memory stacks 734 and 736 (e.g., HBM memory stacks) and a processor die 735 may be provided on the reticle 720-2.

The two reticles 720-1 and 720-2 may be connected to each other via a communication module and this may enable efficient data transmission between components provided on each of the reticles. In addition, the AI accelerators 731 and 733 and the CPUs 732 and 735 respectively provided on the reticles 720-1 and 720-2 may be connected to each other via a communication module (e.g., an NoC communication module) in the wafer.

A voltage regulator VR may be provided on each of the reticles 720-1 and 720-2 and stable power may be supplied to the processor die and the AI accelerator through the voltage regulator. The power management may be performed through a power communication network between the reticle and a substrate 710 and this integrated power management structure may improve the energy efficiency of the system.

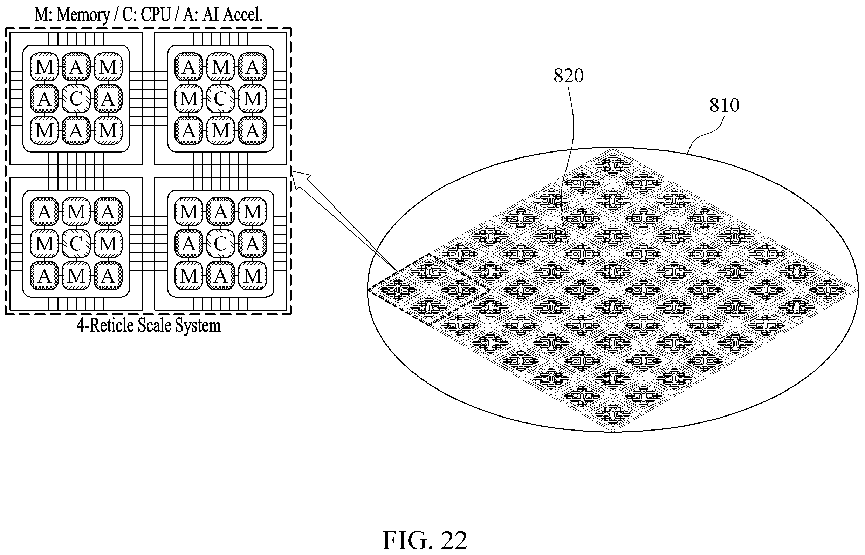

FIG. 22 is a diagram illustrating an example of implementing a wafer-based rack structure in a semiconductor package according to an embodiment. The description provided with reference to FIGS. 5 to 21 may also apply to FIG. 22.

A wafer-based rack structure according to an embodiment may be implemented by integrating a related art rack-based data center architecture into a single wafer. Referring to FIG. 22, a plurality of computing blocks 820 may be integrated into a single wafer 810. Each computing block 820 may include modules including the plurality of processor dies, memory stacks, and AI accelerators described with reference to FIGS. 5 to 21 and the modules may be arranged in a wafer scale. For example, the computing block 820 may include a memory M, a CPU C, and an AI accelerator A. The connection among components in each computing block 820 may be performed through an NoC communication module as described with reference to FIG. 21 or other custom interconnects. For example, the memory, the CPU, and the AI accelerator, may be connected to each other through the NoC communication module as described with reference to FIG. 21 or other custom interconnects. For example, the connection between components in each computing block 820 may enable high-speed data transmission among the processor, the memory, and the AI accelerator in the computing block 820 and efficient communication with other blocks. Accordingly, the wafer-based rack structure may provide excellent performance in the high-performance computing environment that requires a large volume of parallel operations.

According to an embodiment, the wafer-based rack structure may provide a great benefit to an application field that requires big data processing, such as AI operations, machine learning, and big data analysis. Since each computing block may transfer data at high speed, the operation efficiency may be maximized and a response time of the entire system may be reduced.

According to an embodiment, the wafer-based rack structure may be a new architecture beyond the physical limitations of related art data center and may significantly improve the performance while reducing the size and power consumption of the data center by integrating multiple high-performance computing elements into the single wafer 810.

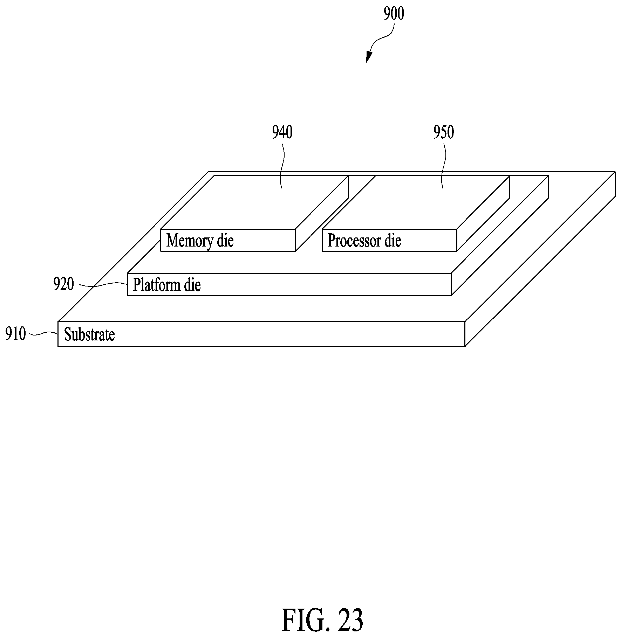

FIG. 23 is a perspective view of a semiconductor package structure according to an embodiment.

Referring to FIG. 23, a semiconductor package 900 according to an embodiment may include a platform die 920 provided on a substrate 910. The platform die 920 may include an active circuitry and one or more main circuitries. For example, the active circuitry may function as a buffer die, and the one or more main circuitries may include a memory controller provided on the platform die 920. A memory die 940 may be provided on the platform die 920. The memory die may be implemented by a volatile memory device or a non-volatile memory device. The volatile memory device may be implemented by DRAM, SRAM, T-RAM, Z-RAM, or TTRAM. The non-volatile memory device may be implemented by EEPROM, flash memory, MRAM, STT-MRAM, CBRAM, FeRAM, PRAM, RRAM, nanotube RRAM, PoRAM, NFGM, holographic memory, a molecular electronic memory device, or an insulator resistance change memory. The types of the memory die 940 are not limited thereto.

The platform die 920 may be a type of a semiconductor chip. The platform die 920 may be implemented by a semiconductor device, and may be referred to as an active interposer. For example, the semiconductor device may be a silicon semiconductor device. Unlike a related art interposer, the platform die 920 may include an active circuitry and main circuitries, such as a memory controller. The platform die 920 may manage and optimize data transfer between the memory die 940 and a processor die 950.

A memory controller may be provided on the platform die 920 to efficiently manage the data transfer between the memory die 940 and the processor die 950. The processor die 950 may be directly connected to the memory controller provided on the platform die 920. Furthermore, since the memory controller is provided on the platform die 920, the processor die 920 may not need to be changed to correspond to the memory die 940 even in an example case in which the type of the memory die 940 is changed.

The processor die 950 may include various processors, such as a CPU, a GPU, and an NPU. One or more of the various processor included in the processor die 950 may allow the processor die 950 to efficiently perform a high-performance computational task, specifically, a machine learning task, such as AI and a DNN. A computing system including the semiconductor package 900 may perform various high-performance computational tasks including machine learning. The machine learning may be used for various application fields including AI, the DNN, data analytics, image processing, and natural language processing.

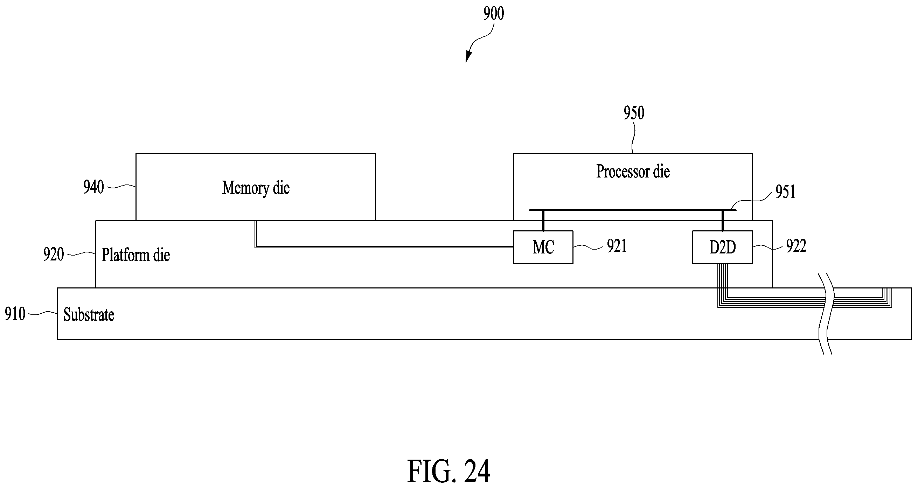

FIG. 24 is a perspective front view of a semiconductor package to describe a system bus structure and a communication module in the semiconductor package according to an embodiment. The description provided with reference to FIG. 23 may apply to the description of FIG. 24.

Referring to FIG. 24, according to an embodiment, a system bus 951 in the semiconductor package 900 may manage the data transfer between the processor die 950 and the platform die 920. The system bus 951 may also be referred to as an on-chip bus (or an on-chip network) and may support communication between various processor cores. The system bus 951 may use an AMBA AXI bus as the system bus 951. The AMBA AXI may be a bus that provides high bandwidth and low latency and may allow high-speed data transfer between a plurality of masters and a slave device. However, the system bus 951 is not limited thereto.

The processor die 950 may include a plurality of processor cores (e.g., a CPU, a GPU, and an NPU), and the cores may be connected to each other via the system bus 951. The system bus 951 may support the processor cores to efficiently communicate with a memory controller 921 and other components or circuitries. For example, the CPU may read or write data in the memory die 940 via the memory controller 921 and this task (e.g., the read or write data task) may be rapidly performed via the system bus 951.

According to an embodiment, a communication module 922 may be included in the semiconductor package 900. The communication module 922 may serve to manage the data transfer between the processor die 950 and other processor dies. The communication module 922 may include a D2D communication module or a C2C communication module. The communication module may use a standard interface, such as UCIe or PCIe. For example, the D2D communication module may use the UCIe standard interface and the C2C communication module may use the PCIe standard interface. The UCIe may be a latest interface standard for high-speed data transfer between chiplets and may enable efficient communication in a chiplet-based design. The UCIe may provide low latency and a high data processing throughput required for a high-performance computing environment. The PCIe may be a widely used high-speed data transfer interface and may support data transfer between internal and external devices of a computer. The PCIe may significantly improve a data transfer rate using a serial communication scheme and may provide scalability and flexibility by adjusting the number of links.

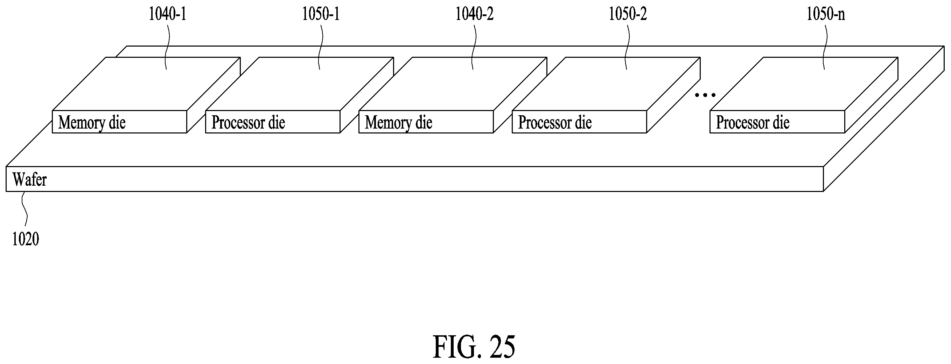

FIG. 25 is a perspective view of a semiconductor package in which a plurality of processor dies and a memory die are provided on a wafer-scale platform chip according to an embodiment. The description provided with reference to FIGS. 5 to 24 may apply to the description of FIG. 25.

Referring to FIG. 25, according to an embodiment, a semiconductor package 1000 having a wafer-scale platform structure may include a wafer-scale platform chip 1020. The wafer-scale platform chip 1020 may include active circuitries and may be regarded as an extension of the function of the platform die described with reference to FIGS. 5 to 15 at a wafer level. Since the wafer-scale platform chip 1020 of the semiconductor package 1000 is a wafer-scale, all wirings may be provided on the wafer. Accordingly, the semiconductor package 100 may not need a separate substrate. The wafer-scale platform chip 1020 may include a memory controller and active circuitries, such as a NoC communication module and a W2W communication module. The components may allow the wafer-scale platform chip 1020 to efficiently manage data communication between a plurality of memory dies 1040-1 and 1040-2 and processor dies 1050-1, 1050-2 to 1050-n (where n is an integer). Each of the memory dies 1040-1 and 1040-2 may use an HBM technique and may perform data storage and transmission. Although FIG. 25 illustrates an example of the semiconductor package 1000 including two memory dies 1040-1 and 1040-2, the semiconductor package 1000 is not limited thereto. As such, according to another embodiment, a number of memory dies may be different than two.

Not all processor dies 1050-1 to 1050-n may be directly connected to a memory die. Some processor dies 1050-1 and 1050-2 may be directly connected to the memory dies 1040-1 and 1040-2 via the memory controller, but some other processor dies (e.g., 1050-n) may not be directly connected to a memory die and may perform a separate task. In this case, the processor die (e.g., 1050-n) may communicate with other processor dies and the memory die via a NoC communication module.

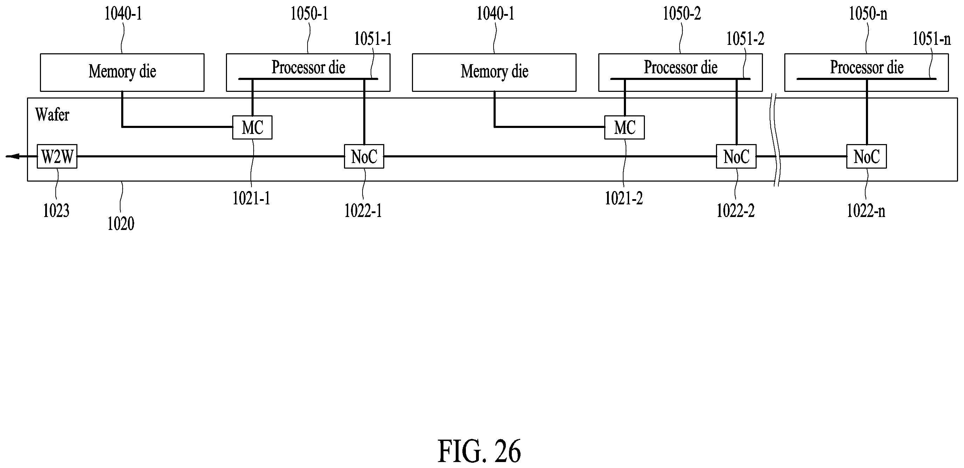

FIG. 26 is a cross-sectional front view of a semiconductor package according to an embodiment. The description provided with reference to FIGS. 5 to 25 may apply to the description of FIG. 26.

Referring to FIG. 26, the semiconductor package 1000 may show a structure in which the plurality of processor dies 1050-1 to 1050-n and the memory dies 1040-1 and 1040-2 are provided on the wafer-scale platform chip 1020.

The memory dies 1040-1 and 1040-2 may be implemented by a volatile memory device or a non-volatile memory device. The volatile memory device may be implemented by DRAM, SRAM, T-RAM, or TTRAM. The non-volatile memory device may be implemented by EEPROM, flash memory, MRAM, STT-MRAM, CBRAM, FeRAM, RRAM, nanotube RRAM, PoRAM, NFGM, holographic memory, a molecular electronic memory device, or insulator resistance change memory. The types of the memory dies 1040-1 and 1040-2 are not limited thereto.

Memory controllers 1021-1 and 1021-2, NoC communication modules 1022-1 to 1022-n, and a W2W communication module 1023 may be provided on the wafer-scale platform chip 1020. The memory controllers 1021-1 and 1021-2 may manage data communication between the memory dies 1040-1 and 1040-2 and the processor dies 1050-1 and 1050-2. For example, the processor dies 1050-1 and 1050-2 may be connected to the memory controllers 1021-1 and 1021-2 and the NoC communication modules 1022-1 and 1022-2, respectively, and the connection may be performed by sharing the same bus, such as system buses 1051-1 and 1051-2. For example, the processor die 1050-1 may be connected to the memory controller 1021-1 and the NoC communication module 1022-1 and the connection may share the system bus 1051-1. For example, the processor die 1050-1 may be connected to both the memory controller 1021-1 and the NoC communication module 1022-1 via the same system bus 1051-1.

However, as described above, a specific processor die (e.g., 1050-n) may not be directly connected to the memory die and may operate independently. The processor die 1050-n may be connected to the NoC communication module 1022-n and the connection may share the system bus 1051-n. The processor die (e.g., 1050-n) may communicate with other processor dies and memory dies via the NoC communication module 1022-n connected thereto. The NoC communication modules 1022-1 to 1022-n may support the data transfer between processor dies 1050-1 to 1050-n in the wafer and may significantly improve the flexibility and scalability of the system. An NoC structure in the wafer-scale platform chip 1020 may allow each processor die to transmit and receive data to or from other processor dies or memory dies as necessary. Accordingly, the system may efficiently process a complex computational task and may achieve the optimal performance in various application programs.

In addition, the W2W communication module 1023 may support wafer-to-wafer communication and may enable data synchronization and communication among multiple wafers. Through the W2W communication module 1023, the semiconductor package 1000 may efficiently perform data transfer and cooperative tasks even in an expanded system across multiple wafers.

The structure of the semiconductor package 1000 according to an embodiment may maximize the efficiency of data transfer and may be advantageous in the high-performance computing environment that requires large-scale parallel computations.

The embodiments described herein may be implemented using a hardware component, a software component and/or a combination thereof. A processing device may be implemented using one or more general-purpose or special-purpose computers, such as, for example, a processor, a controller and an arithmetic logic unit (ALU), a DSP, a microcomputer, an FPGA, a programmable logic unit (PLU), a microprocessor or any other device capable of responding to and executing instructions in a defined manner. The processing device may run an operating system (OS) and one or more software applications that run on the OS. The processing device also may access, store, manipulate, process, and create data in response to execution of the software. For purpose of simplicity, the description of a processing device is used as singular; however, one skilled in the art will appreciate that a processing device may include multiple processing elements and multiple types of processing elements. For example, a processing device may include multiple processors or a processor and a controller. In addition, different processing configurations are possible, such as parallel processors.

The software may include a computer program, a piece of code, an instruction, or combinations thereof, to independently or uniformly instruct or configure the processing device to operate as desired. Software and data may be embodied permanently or temporarily in any type of machine, component, physical or virtual equipment, computer storage medium or device, or in a propagated signal wave capable of providing instructions or data to or being interpreted by the processing device. The software also may be distributed over network-coupled computer systems so that the software is stored and executed in a distributed fashion. The software and data may be stored by one or more non-transitory computer-readable recording mediums.

The methods according to the above-described examples may be recorded in non-transitory computer-readable media including program instructions to implement various operations of the above-described example embodiments. The media may also include, alone or in combination with the program instructions, data files, data structures, and the like. The program instructions recorded on the media may be those specially designed and constructed for the purposes of example embodiments, or they may be of the kind well-known and available to those having skill in the computer software arts. Examples of non-transitory computer-readable media include magnetic media such as hard disks, floppy disks, and magnetic tape; optical media such as CD-ROM discs, DVDs, and/or Blue-ray discs; magneto-optical media such as optical discs; and hardware devices that are specially configured to store and perform program instructions, such as read-only memory (ROM), random access memory (RAM), flash memory (e.g., USB flash drives, memory cards, memory sticks, etc.), and the like. Examples of program instructions include both machine code, such as produced by a compiler, and files containing higher-level code that may be executed by the computer using an interpreter.

While this disclosure includes specific examples, it will be apparent to one of ordinary skill in the art that various changes in form and details may be made in these examples without departing from the scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

## Claims

1. A semiconductor package comprising:
an active platform die including a memory controller;
a memory die stack comprising a stack of at least one memory die, said memory die stack being provided on the platform die; and
a processor die provided on the platform die and provided adjacent to the memory die stack;
wherein the memory controller is configured to control data communication between the memory die stack and the processor die.

2. The semiconductor package of claim 1, wherein the memory die stack is configured to transmit data through direct connection to the memory controller.

3. The semiconductor package of claim 2, wherein each memory die of the memory die stack is physically connected to the platform die by means of through vias, wherein an electrical connection between the memory die stack and the platform die is made with the through vias;
wherein data lines of the at least one memory die are connected to the platform die as the data lines are drawn to the platform die by using the through vias.

4. The method according to claim 3, wherein the electrical connection between the memory die stack and the platform die is further made with data pins, said data pins including micro bumps, bumps such as Solder or Copper bumps, or wherein the memory dies stack is hybridly bonded to the platform die.

5. The semiconductor package of any of the claims 3 or 4, wherein a number of the data lines between the memory dies of the memory die stack is the same as a number of data lines between the memory die stack and the memory controller.

6. The semiconductor package of any of the previous claims, wherein the platform die comprises a buffer configured to adjust a signal between the at least one memory die and the memory controller.

7. The semiconductor package of any of the previous claims, wherein the memory controller shares a system bus with the processor die.

8. The semiconductor package of claim 7, wherein the processor die comprises a plurality of processor cores, and wherein the memory controller is connected to the plurality of processor cores via the system bus; and/or
wherein the memory controller is connected to the system bus based on hybrid bonding.

9. The semiconductor package of any of the claims 7-8, wherein:
the processor die comprises a first interface circuit,
the platform die comprises a second interface circuit,
the first interface circuit is configured to serialize data received from the system bus and deserialize data received from the second interface circuit, and
the second interface circuit is configured to serialize data received from the memory controller and deserialize data received from the first interface circuit.

10. The semiconductor package of any of the claims 7-9, wherein the memory controller comprises a bus having a different protocol from the system bus, and
wherein the processor die comprises a bridge module configured to mediate communication between the bus of the memory controller and the system bus.

11. The semiconductor package of any of the previous claims, wherein the platform die comprises a communication module configured to communicate between the processor die and another processor die, wherein the communication module preferably shares a system bus with the processor die.

12. The semiconductor package of any of the previous claims, wherein the platform die comprises a test module, a voltage regulator, and/or a static random access memory (SRAM) that is preferably configured to operate a cache of the processor die.

13. The semiconductor package of any of the previous claims, further comprising a substrate on which the platform die is provided.

14. A semiconductor package comprising:
a wafer-scale platform chip; and
a memory die stack comprising a stack of a plurality of memory dies provided on the wafer-scale platform chip; and
a plurality of processor dies provided on the wafer-scale platform chip;
wherein the wafer-scale platform chip comprises:
a memory controller configured to control data communication between the plurality of memory dies and the plurality of processor dies, and
a communication module configured to communicate with the plurality of processor dies.

15. The semiconductor package of claim 14, wherein the memory controller and the communication module share a system bus with the plurality of processor dies; and/or
wherein the memory controller and the communication module are directly connected to each other in the wafer-scale platform chip; and/or
wherein the wafer-scale platform chip comprises an external communication module configured to communicate with a device outside of the wafer-scale platform chip, and wherein the communication module is connected to the external communication module; and/or
wherein each of the plurality of memory dies comprises a memory stack comprising stacked memory dies.
